# EUROPEAN PATENT APPLICATION

(11) **EP 4 451 354 A1**
(43) Date of publication of application: **23.10.2024**
(21) Application number: 22907956.1
(22) Date of filing: 15.12.2022
(51) Int. Cl.: H01L 33/50, H01L 33/08, H01L 33/58, H01L 33/52, H01L 33/38, H01L 27/15

(54) **DISPLAY DEVICE**

(30) Priority: 16.12.2021 KR 20210180238
(71) Applicant: Samsung Display Co., Ltd., Gyeonggi-do 17113 (KR)
(72) Inventor: SHIN, Dong Hee, Yongin-si Gyeonggi-do 17113 (KR); CHA, Na Hyeon, Yongin-si Gyeonggi-do 17113 (KR); SON, Sun Kwun, Yongin-si Gyeonggi-do 17113 (KR)
(74) Representative: Marks & Clerk LLP
(86) International application number: PCT/KR2022/020429
(87) International publication number: WO 2023/113489

(57) **Abstract**

A display device is provided. The display device comprises a first substrate including a display area and a non-display area surrounding the display area, a plurality of sub-pixels including a plurality of light emitting elements disposed on the first substrate in the display area, a first bank surrounding the sub-pixels in the display area, a plurality of color control structures disposed in areas surrounded by the first bank on the light emitting elements of the plurality of sub-pixels, a plurality of color filter layers disposed on the color control structures, a second bank spaced apart from the first bank and surrounding the display area in the non-display area, and a plurality of color dams disposed on the second bank, wherein the color dams include a first color dam disposed on a portion of the second bank disposed on a first side of the display area and a second color dam disposed on a portion of the second bank disposed on a second side of the display area opposite to the first side, and the first color dam and the second color dam include different materials.

## Description

### [TECHNICAL FIELD]

The disclosure relates to a display device.

### [BACKGROUND ART]

Display devices are becoming more important with developments in multimedia technology. Accordingly, various display devices such as an organic light-emitting diode (OLED) display device, a liquid crystal display (LCD) device, and the like have been used.

A typical display device includes a display panel such as an organic light-emitting display panel or a liquid crystal display (LCD) panel. A light-emitting display panel may include light-emitting elements. For example, light-emitting diodes (LEDs) include organic light-emitting diodes (OLEDs) using an organic material as a fluorescent material and inorganic LEDs using an inorganic material as a fluorescent material.

### [DISCLOSURE]

### [TECHNICAL PROBLEM]

Aspects of embodiments of the present disclosure provide a display device including a structure capable of blocking overflowing of organic materials into undesired areas of the display device.

It should be noted that aspects of the present disclosure are not limited to the above-mentioned aspects, and other unmentioned aspects of the present disclosure will be clearly understood by those skilled in the art from the following description.

### [TECHNICAL SOLUTION]

According to an embodiment of the disclosure, a display device includes a first substrate including a display area and a non-display area surrounding the display area, a plurality of sub-pixels including a plurality of light emitting elements disposed on the first substrate in the display area, a first bank surrounding the sub-pixels in the display area, a plurality of color control members disposed in an area surrounded by the first bank on the light emitting elements of the plurality of sub-pixels, a plurality of color filter layers disposed on the color control members, a second bank spaced apart from the first bank and surrounding the display area in the non-display area, and a plurality of color dams disposed on the second bank, wherein the plurality of color dams include a first color dam disposed on a first portion of the second bank disposed on a first side of the display area, and a second color dam disposed on a second portion of the second bank disposed on a second side of the display area opposite to the first side of the display area, and the first color dam and the second color dam include different materials.

The plurality of sub-pixels may include a first sub-pixel and a second sub-pixel spaced apart from the first sub-pixel in one direction, the plurality of color control members may include a first wavelength conversion layer disposed in the first sub-pixel and a light transmitting layer disposed in the second sub-pixel, and the plurality of color filter layers may include a first color filter layer disposed on the first wavelength conversion layer and a second color filter layer disposed on the light transmitting layer.

The first color dam and the second color dam may be spaced apart from each other in the direction, the display area may be disposed between the first color dam and the second color dam, and the first color dam and the first color filter layer may include a same material, and the second color dam and the second color filter layer may include a same material.

The plurality of sub-pixels may further include a third sub-pixel disposed between the first sub-pixel and the second sub-pixel, the plurality of color control members may further include a second wavelength conversion layer disposed in the third sub-pixel, and the plurality of color filter layers may further include a third color filter layer disposed on the second wavelength conversion layer, the display device may further include a third color dam disposed on the first color dam and the third color dam and the third color filter layer may include a same material.

A width of the third color dam may be greater than a width of the first color dam, and an outer surface of the first color dam may be covered by the third color dam.

The display device may further include a plurality of color patterns overlapping the first bank, wherein the color patterns may include a first color pattern, the first color pattern and the first color filter layer including a same material, a second color pattern, the second color pattern and the second color filter layer including a same material, and a third color pattern, the third color pattern and the third color filter layer including a same material, and the first color pattern may overlap each of the second color filter layer and the third color filter layer.

The first color dam and the second color dam may be spaced apart from each other in the one direction, the display area may be disposed between the first color dam and the second color dam, and the first color dam and the second color filter layer may include a same material, and the second color dam and the first color filter layer may include a same material.

The display device may further include a first capping layer disposed on the color control members, the first bank, and the second bank, a low refraction layer disposed on the first capping layer, and a second capping layer disposed on the low refraction layer, wherein the first color dam and the second color dam may be disposed on the second capping layer.

The display device may further include a planarization layer disposed between the second capping layer and the plurality of color filter layers, wherein each of the first color dam and the second color dam may be directly disposed on the planarization layer on the second bank.

The display device may further include a light blocking member disposed on the planarization layer and overlapping the first bank, and an overcoat layer disposed on the light blocking member and the plurality of color filter layers.

The display device may further include a via layer disposed in the display area and the non-display area on the first substrate, a third bank disposed on the via layer, spaced apart from the second bank in the non-display area, and surrounding the second bank, and a first valley part disposed between the first bank and the second bank in the non-display area and penetrating through the via layer.

A plurality of first color dams may be disposed respectively on portions of the second bank and the third bank disposed on the first side of the display area, and a plurality of second color dams may be disposed respectively on portions of the second bank and the third bank disposed on the second side of the display area.

The display device may further include a plurality of bank partition walls directly disposed on the via layer between the first bank and the first valley part.

Each of the first bank and the second bank may include a base layer and an upper layer disposed on the base layer, and the upper layer may have a greater width than the base layer.

The plurality of sub-pixels may include a plurality of electrodes extending in a direction and spaced apart from each other, and the plurality of light emitting elements may be disposed on the plurality of electrodes spaced apart from each other.

Each of the light emitting elements may include a first electrode disposed on the first substrate, an organic layer disposed on the first electrode, and a second electrode disposed on the organic layer.

According to an embodiment of the disclosure, a display device includes a display area and a non-display area surrounding the display area, a plurality of sub-pixels disposed in the display area, arranged in a first direction and a second direction intersecting the first direction, and each of the plurality of sub-pixels including: a first electrode, a second electrode spaced apart from the first electrode, and a plurality of light emitting elements including first and second ends disposed on the first electrode and the second electrode, respectively, a first bank extending in the first direction and the second direction in the display area and surrounding the plurality of sub-pixels, a plurality of color control members disposed in an area surrounded by the first bank, a plurality of color filter layers disposed on the plurality of color control members, a first valley part spaced apart from the first bank and surrounding the first bank in the non-display area, a second bank spaced apart from the first valley part and surrounding the first valley part in the non-display area, a third bank spaced apart from the second bank and surrounding the second bank in the non-display area, a plurality of first color dams extending in the first direction in a first dam area of the non-display area adjacent to a first side of the display area in the second direction, and a plurality of second color dams extending in the first direction in a second dam area of the non-display area adjacent to a second side of the display area in the second direction in the non-display area, wherein the plurality of first color dams and the plurality of second color dams include different materials.

The plurality of first color dams may overlap the second bank and the third bank disposed in a first dam area adjacent to the first side of the display area, and the plurality of second color dams may overlap the second bank and the third bank disposed adjacent to the second side of the display area.

The plurality of color filter layers may include a plurality of first color filter layers, a plurality of second color filter layers spaced apart from the plurality of first color filter layers in the second direction and a plurality of third color filter layers spaced apart from the plurality of second color filter layers in the second direction, the first color filter layers, the second color filter layers, and the third color filter layers may be adjacent to each other in the second direction, the plurality of first color dams and the third color filter layer may include a same material, and the plurality of second color dams and the first color filter layer may include a same material.

The display device may further include third color dams disposed on the second color dams, wherein the third color dams and the second color dams include a same material.

The details of other embodiments are included in the detailed description and the accompanying drawings.

### [ADVANTAGEOUS EFFECTS]

According to the aforementioned and other embodiments of the disclosure, a display device may include a plurality of color dams disposed in a non-display area as structures disposed at an outer portion of a display area. The color dams may include a same material as any one of the color filter layers of the display device, but the color dams disposed at different outer portions may include different materials. In the display device, the overflowing of the organic material may be prevented by adding a a minimum number of process steps as the different color dams may be formed together with different color filter layers in processes of forming the different color filter layers.

The effects according to the embodiments are not limited by the contents exemplified above, and more various effects are included in this disclosure.

### [DESCRIPTION OF DRAWINGS]

FIG. 1 is a schematic plan view of a display device according to an embodiment.
FIG. 2 is a schematic plan view illustrating one pixel of the display device according to an embodiment.
FIG. 3 is a schematic cross-sectional view taken along line N1-N1' of FIG. 2.
FIG. 4 is a schematic cross-sectional view taken along line N2-N2' of FIG. 2.
FIG. 5 is a schematic view of a light emitting element according to an embodiment.
FIG. 6 is a schematic cross-sectional view of the display device according to an embodiment.
FIG. 7 is a schematic schematic view illustrating banks disposed in a display area and a non-display area of the display device according to an embodiment.
FIG. 8 is a schematic cross-sectional view taken along line A1-A1' of FIG. 7.
FIG. 9 is a schematic cross-sectional view taken along line A2-A2' of FIG. 7.
FIG. 10 is a schematic view illustrating an arrangement of color filter layers and color dams of the display device according to an embodiment.
FIG. 11 is a schematic view illustrating mask processes for forming first color filter layers and first color dams of the display device according to an embodiment.
FIG. 12 is a schematic view illustrating mask processes for forming second color filter layers of the display device according to an embodiment.
FIG. 13 is a schematic view illustrating mask processes for forming third color filter layers and second color dams of the display device according to an embodiment.
FIG. 14 is a schematic cross-sectional view of a display device according to an embodiment.
FIG. 15 is a schematic cross-sectional view illustrating an outer portion of the display device of FIG. 14.
FIG. 16 is a schematic cross-sectional view illustrating an outer portion of a display device according to an embodiment.
FIG. 17 is a schematic view illustrating an arrangement of color filter layers and color dams of the display device according to an embodiment.
FIGS. 18 and 19 are schematic cross-sectional views illustrating an outer portion of the display device of FIG. 17.
FIG. 20 is a schematic cross-sectional view of a display device according to an embodiment.
FIG. 21 is a schematic cross-sectional view illustrating an outer portion of the display device of FIG. 20.
FIGS. 22 and 23 are schematic cross-sectional views illustrating outer portions of display devices according embodiments.
FIG. 24 is a schematic plan view illustrating one sub-pixel of a display device according to an embodiment.
FIG. 25 is a schematic cross-sectional view taken along line N3-N3' of FIG. 24.
FIG. 26 is a schematic cross-sectional view taken along line N4-N4' of FIG. 24.
FIG. 27 is a schematic plan view illustrating one sub-pixel of a display device according to an embodiment.
FIG. 28 is a schematic cross-sectional view taken along line N5-N5' of FIG. 27.
FIG. 29 is a schematic cross-sectional view taken along line N6-N6' of FIG. 27.
FIG. 30 is a schematic cross-sectional view taken along line N7-N7' of FIG. 27.
FIG. 31 is a schematic cross-sectional view of a display device according to an embodiment.
FIG. 32 is a schematic cross-sectional view illustrating an outer portion of the display device of FIG. 31.
FIG. 33 is a schematic cross-sectional view illustrating an outer portion of a display device according to an embodiment.

### [MODES OF THE INVENTION]

The present disclosure will now be described more fully hereinafter with reference to the accompanying drawings, in which preferred embodiments of the disclosure are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

Hereinafter, embodiments will be described with reference to the accompanying drawings.

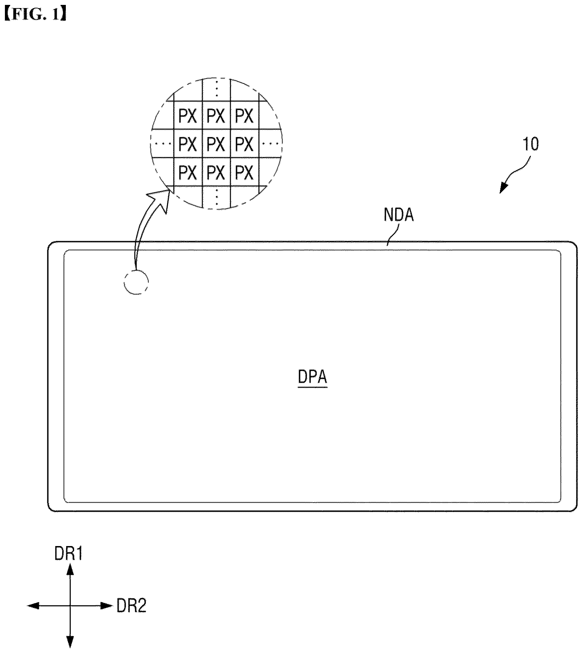

FIG. 1 is a schematic plan view of a display device according to an embodiment.

Referring to FIG. 1, a display device 10 may display a moving image or a still image. The display device 10 may refer to all electronic devices that provide display screens. For example, televisions, laptop computers, monitors, billboards, the Internet of Things (IoT), mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras, camcorders, and the like, which provide display screens, may be included in the display device 10.

The display device 10 may include a display panel with the display screen. Examples of the display panel may include an inorganic light emitting diode display panel, an organic light emitting display panel, a quantum dot light emitting display panel, a plasma display panel, a field emission display panel, and the like. Hereinafter, a case where an inorganic light emitting diode display panel is applied as an example of the display panel will be described, but embodiments are not limited thereto, and the embodiments may be applied to other display panels.

A shape of the display device 10 may be variously modified. For example, the display device 10 may have a shape such as a rectangular shape with a width greater than a length, a rectangular shape with a length greater than a width, a square shape, a rectangular shape with rounded corners (e.g., vertices), other polygonal shapes, or a circular shape. For example, a display area DPA of the display device 10 may have a shape similar to an overall shape of the display device 10. In FIG. 1, the display device 10 having a rectangular shape with a long length in a second direction DR2 is illustrated.

The display device 10 may include a display area DPA and non-display areas NDA. The display area DPA is an area in which an image may be displayed, and the non-display areas NDA are areas in which an image is not displayed. The display area DPA may also be referred to as an active area, and the non-display area NDA may also be referred to as a non-active area. The display area DPA may substantially occupy or cover the center of the display device 10.

The display area DPA may include pixels PX. The pixels PX may be arranged in a matrix direction. A shape of each pixel PX may be a rectangular shape or a square shape in a plan view, but is not limited thereto, and may also be a rhombic shape of which each side is inclined with respect to a direction. The respective pixels PX may be alternately arranged in a stripe type or an island type. For example, each of the pixels PX may include one or more light emitting elements emitting light of a specific wavelength band corresponding to a specific color.

The non-display areas NDA may be disposed around the display area DPA. The non-display areas NDA may entirely or partially surround the display area DPA. The display area DPA may have a rectangular shape, and the non-display areas NDA may be disposed adjacent to four sides of the display area DPA. The non-display areas NDA may constitute a bezel of the display device 10. Lines or circuit drivers included in the display device 10 may be disposed in the non-display areas NDA, and external devices may be mounted in the non-display areas NDA.

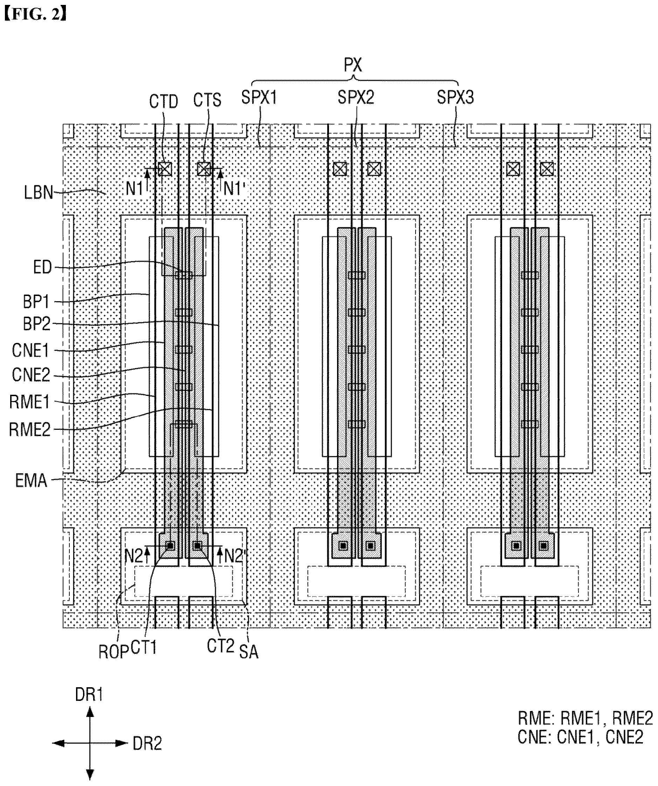

FIG. 2 is a schematic plan view illustrating a representative pixel of the display device according to an embodiment. FIG. 2 illustrates a layout, in a plan view, of electrodes RME (e.g., RME1 and RME2), bank patterns BP1 and BP2, a lower bank layer LBN, light emitting elements ED, and connection electrodes CNE (e.g., CNE1 and CNE2) disposed in a pixel PX of the display device 10.

Referring to FIG. 2, each of the pixels PX of the display device 10 may include sub-pixels SPXn. For example, the pixel PX may include a first sub-pixel SPX1, a second sub-pixel SPX2, and a third sub-pixel SPX3. The first sub-pixel SPX1 may emit light of a first color, the second sub-pixel SPX2 may emit light of a second color, and the third sub-pixel SPX3 may emit light of a third color. As an example, the first color may be blue, the second color may be green, and the third color may be red. However, embodiments are not limited thereto, and the respective sub-pixels SPXn may also emit light of the same color. In an embodiment, the respective sub-pixels SPXn may emit blue light. FIG. 2 illustrates that the pixel PX includes three sub-pixels SPXn, but embodiments are not limited thereto, and the pixel PX may include the larger number of sub-pixels SPXn.

Each of the sub-pixels SPXn of the display device 10 may include an emission area EMA and a non-emission area. The emission area EMA may be an area in which the light emitting elements ED emit light of a specific wavelength band. The non-emission area may be an area in which the light emitting elements ED are not disposed and light emitted from the light emitting elements ED does not arrive, and thus, the light is not emitted.

The emission area EMA may include an area in which the light emitting elements ED are disposed and an area adjacent to the light emitting elements ED. For example, the light emitted from the light emitting elements ED may be emitted in the emission area EMA. For example, the emission area EMA may also include an area in which the light emitted from the light emitting elements ED is reflected or refracted by other members to be emitted. The light emitting elements ED may be disposed in each sub-pixel SPXn, and the emission area EMA be formed to include an area in which the light emitting elements ED are disposed and an area adjacent to the light emitting elements ED.

FIG. 2 illustrates that the emission areas EMA of the respective sub-pixels SPXn have a substantially uniform area, but embodiments are not limited thereto. In some embodiments, the respective emission areas EMA of the respective sub-pixels SPXn may also have different areas according to colors or wavelength bands of light emitted from the light emitting elements ED disposed in the corresponding sub-pixels.

Each sub-pixel SPXn may further include a sub-area SA disposed in the non-emission area. The sub-area SA of each sub-pixel SPXn may be disposed on the lower side of the emission area EMA, which is the other side of the emission area EMA in a first direction DR1. The emission areas EMA and the sub-areas SA may be alternately arranged along the first direction DR1, and the sub-area SA may be disposed between the emission areas EMA of different sub-pixels SPXn spaced apart from each other in the first direction DR1. For example, the emission areas EMA and the sub-areas SA may be alternately arranged in the first direction DR1, and each of the emission areas EMA and the sub-areas SA may be repeatedly arranged in the second direction DR2. However, embodiments are not limited thereto, and the emission areas EMA and the sub-areas SA of the pixels PX may also have an arrangement different from that of FIG. 2.

Light may not be emitted in the sub-areas SA because the light emitting elements ED are not disposed in the sub-areas SA, but portions of electrodes RME disposed in each of the sub-pixels SPXn may be disposed in the sub-areas SA. The electrodes RME disposed in different sub-pixels SPXn may be separated from each other in a separation part ROP of the sub-area SA.

Lines and circuit elements of a circuit layer may be connected to the first to third sub-pixels SPX1, SPX2, and SPX3, respectively. However, the lines and the circuit elements may not be disposed to correspond to an area occupied by each sub-pixel SPXn or emission area EMA, but may be disposed regardless of a position of the emission area EMA within one pixel PX.

The lower bank layer LBN may surround the sub-pixels SPXn and the emission areas EMA and the sub-areas SA. The lower bank layer LBN may be disposed at boundaries between the sub-pixels SPXn adjacent to each other in the first direction DR1 and the second direction DR2, and may also be disposed at boundaries between the emission areas EMA and the sub-areas SA. The sub-pixels SPXn, the emission areas EMA, and the sub-areas SA of the display device 10 may be areas divided by an arrangement of the lower bank layer LBN. Intervals between the sub-pixels SPXn, the emission areas EMA, and the sub-areas SA may vary according to a width of the lower bank layer LBN.

The lower bank layer LBN may be disposed in a lattice-shaped pattern in the entirety of the display area DPA by including portions extending in the first direction DR1 and the second direction DR2 in a plan view. The lower bank layer LBN may be disposed across boundaries between the respective sub-pixels SPXn to divide neighboring (e.g., adjacent) sub-pixels SPXn. For example, the lower bank layer LBN may surround the emission area EMA and the sub-area SA disposed for each sub-pixel SPXn to divide the emission area EMA and the sub-area SA.

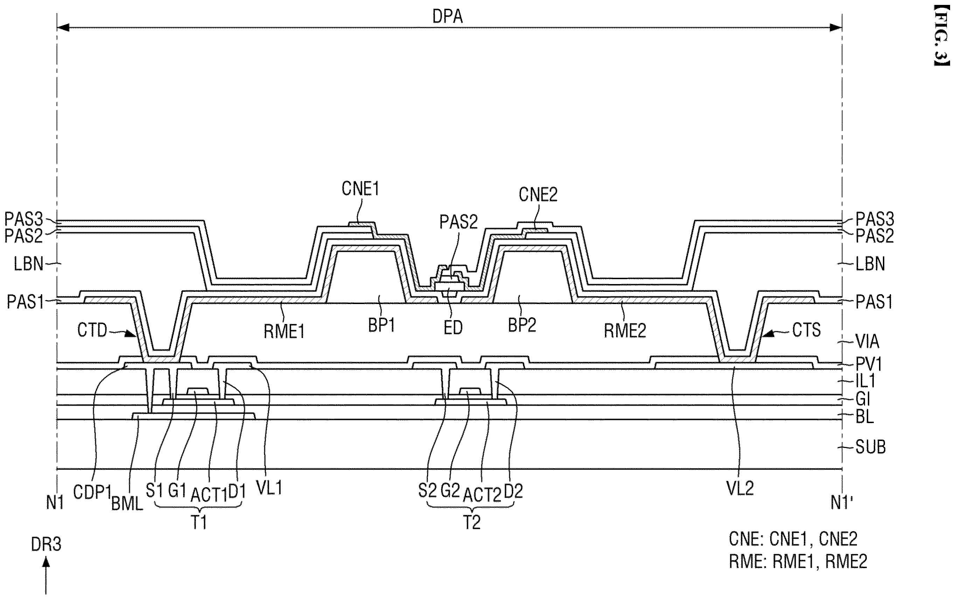

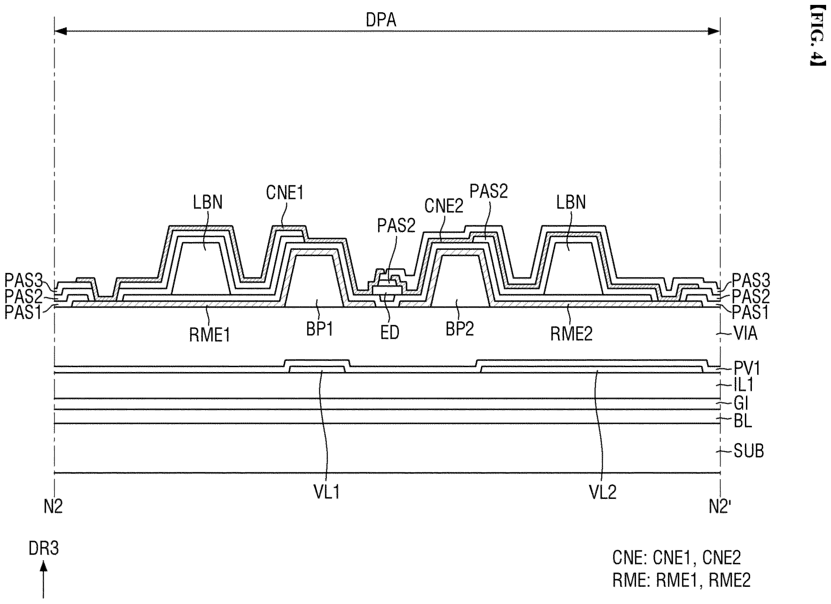

FIG. 3 is a schematic cross-sectional view taken along line N1-N1' of FIG. 2. FIG. 4 is a schematic cross-sectional view taken along line N2-N2' of FIG. 2. FIG. 3 illustrates a cross section crossing both ends (e.g., first and second ends or opposite ends) of the light emitting element ED and electrode contact holes CTD and CTS disposed in the first sub-pixel SPX1, and FIG. 4 illustrates a cross section crossing both ends of the light emitting element ED and contact parts CT1 and CT2 disposed in the first sub-pixel SPX1.

Referring to FIGS. 3 and 4 in conjunction with FIG. 2, the display device 10 may include a first substrate SUB, and a semiconductor layer, conductive layers, and insulating layers disposed on the first substrate SUB. The semiconductor layer, the conductive layers, and the insulating layers may constitute a circuit layer and a display element layer of the display device 10, respectively.

The first substrate SUB may be an insulating substrate. The first substrate SUB may be made of an insulating material such as glass, quartz, or a polymer resin. For example, the first substrate SUB may be a rigid substrate, but may also be a flexible substrate that is bendable, foldable, or rollable. The first substrate SUB may include a display area DPA and a non-display area NDA surrounding the display area DPA, and the display area DPA may include an emission area EMA and a sub-area SA, which is a portion of a non-emission area.

A first conductive layer may be disposed on the first substrate SUB. The first conductive layer may include a lower metal layer BML, and the lower metal layer BML may overlap a first active layer ACT1 of a first transistor T1. The lower metal layer BML may prevent light from being incident on the first active layer ACT1 of the first transistor or may be connected to (e.g., electrically connected to) the first active layer ACT1 to serve to stabilize electrical characteristics of the first transistor T1. However, the lower metal layer BML may be omitted.

A buffer layer BL may be disposed on the lower metal layer BML and the first substrate SUB. The buffer layer BL may be formed on the first substrate SUB in order to protect transistors of the pixel PX from moisture permeating through the first substrate SUB vulnerable to moisture permeation, and may perform a surface planarization function.

The semiconductor layer may be disposed on the buffer layer BL. The semiconductor layer may include the first active layer ACT1 of the first transistor T1 and a second active layer ACT2 of a second transistor T2. The first active layer ACT1 and the second active layer ACT2 may partially (or entirely) overlap a first gate electrode G1 and a second gate electrode G2 of a second conductive layer as described below, respectively.

The semiconductor layer may include polycrystalline silicon, single crystal silicon, an oxide semiconductor, or the like. In an embodiment, the semiconductor layer may include polycrystalline silicon. The oxide semiconductor may be an oxide semiconductor containing indium (In). For example, the oxide semiconductor may be at least one of indium tin oxide (ITO), indium zinc oxide (IZO), indium gallium oxide (IGO), indium zinc tin Oxide (IZTO), indium gallium tin oxide (IGTO), indium gallium zinc oxide (IGZO), and indium gallium zinc tin oxide (IGZTO).

In the drawings, one first transistor T1 and one second transistor T2 are illustrated to be disposed in the sub-pixel SPXn of the display device 10, but embodiments are not limited thereto, and the display device 10 may include the larger number of transistors.

A first gate insulating layer GI may be disposed on the semiconductor layer and the buffer layer BL. The first gate insulating layer GI may serve as a gate insulating film of each of the transistors T1 and T2.

A second conductive layer may be disposed on the first gate insulating layer GI. The second conductive layer may include the first gate electrode G1 of the first transistor T1 and the second gate electrode G2 of the second transistor T2. The first gate electrode G1 may overlap a channel region of the first active layer ACT1 in a third direction DR3 (e.g., a thickness direction), and the second gate electrode G2 may overlap a channel region of the second active layer ACT2 in the third direction DR3 (e.g., the thickness direction). For example, the second conductive layer may further include one electrode of a storage capacitor.

A first interlayer insulating layer IL1 may be disposed on the second conductive layer. The first interlayer insulating layer IL1 may function as an insulating film between the second conductive layer and other layers disposed on the first interlayer insulating layer IL1, and protect the second conductive layer.

A third conductive layer may be disposed on the first interlayer insulating layer IL1. The third conductive layer may include a first voltage line VL1 and a second voltage line VL2, a first conductive pattern CDP1, and source electrodes S1 and S2 and drain electrodes D1 and D2 of the respective transistors T1 and T2 disposed in the display area DPA. For example, the third conductive layer may further include the other electrode of the storage capacitor.

A high potential voltage (e.g., a first source voltage) transferred to a first electrode RME1 may be applied to the first voltage line VL1, and a low potential voltage (e.g., a second source voltage) transferred to a second electrode RME2 may be applied to the second voltage line VL2. A portion of the first voltage line VL1 may be in contact with the first active layer ACT1 of the first transistor T1 through a contact hole penetrating through the first interlayer insulating layer IL1 and the first gate insulating layer GI. The first voltage line VL1 may serve as a first drain electrode D1 of the first transistor T1. The second voltage line VL2 may be directly connected to a second electrode RME2 as described below.

The first conductive pattern CDP1 may be in contact with the first active layer ACT1 of the first transistor T1 through a contact hole penetrating through the first interlayer insulating layer IL1 and the first gate insulating layer GI. The first conductive pattern CDP1 may be in contact with the lower metal layer BML through another contact hole. The first conductive pattern CDP1 may serve as a first source electrode S1 of the first transistor T1. For example, the first conductive pattern CDP1 may be connected to a first electrode RME1 or a first connection electrode CNE1 as described below. The first transistor T1 may transfer the first source voltage applied from the first voltage line VL1 to the first electrode RME1 or the first connection electrode CNE1.

A second source electrode S2 and a second drain electrode D2 may be in contact with the second active layer ACT2 of the second transistor T2 through contact holes penetrating through the first interlayer insulating layer IL1 and the first gate insulating layer GI, respectively.

A first passivation layer PV1 may be disposed on the third conductive layer. The first passivation layer PV1 may function as an insulating film between the third conductive layer and other layers and protect the third conductive layer.

Each of the buffer layer BL, the first gate insulating layer GI, the first interlayer insulating layer IL1, and the first passivation layer PV1 described above may be formed as inorganic layers that are alternately stacked each other. For example, each of the buffer layer BL, the first gate insulating layer GI, the first interlayer insulating layer IL1, and the first passivation layer PV1 may be formed as a double layer in which inorganic layers including at least one of silicon oxide (SiOₓ), silicon nitride (SiNₓ), and silicon oxynitride (SiOₓN_{y}) are stacked or multiple layers in which these layers are alternately stacked each other. However, embodiments are not limited thereto, each of the buffer layer BL, the first gate insulating layer GI, the first interlayer insulating layer IL1, and the first passivation layer PV1 may also be formed as an inorganic layer including the above-described insulating material. For example, in some embodiments, the first interlayer insulating layer IL1 may also be made of an organic insulating material such as polyimide (PI).

Each of the second conductive layer and the third conductive layer may be formed as a single layer or multiple layers made of any one of molybdenum (Mo), aluminium (Al), chromium (Cr), gold (Au), titanium (Ti), nickel (Ni), neodymium (Nd), and copper (Cu), or alloys thereof. However, embodiments are not limited thereto.

A via layer VIA may be disposed on the third conductive layer in the display area DPA. The via layer VIA may include an organic insulating material, for example, an organic insulating material such as polyimide (PI) to compensate for a step due to lower conductive layers and make an upper surface flat. However, in some embodiments, the via layer VIA may be omitted.

The bank patterns BP1 and BP2, electrodes RME (e.g., RME1 and RME2), the lower bank layer LBN, the light emitting elements ED, and connection electrodes CNE (e.g., CNE1 and CNE2) are disposed as a display element layer on the via layer VIA. For example, insulating layers PAS1, PAS2, and PAS3 may be disposed on the via layer VIA.

Bank patterns BP1 and BP2 may be disposed in the emission area EMA of each sub-pixel SPXn. The bank patterns BP1 and BP2 may have a width (e.g., as predetermined) in the second direction DR2, and may have a shape (e.g., a rectangular shape) in which they extend in the first direction DR1.

For example, the bank patterns BP1 and BP2 may include a first bank pattern BP1 and a second bank pattern BP2 spaced apart from each other in the second direction DR2 within the emission area EMA of each sub-pixel SPXn. The first bank pattern BP1 may be disposed on the left side, which is one side of the center of the emission area EMA in the second direction DR2, and the second bank patterns BP2 may be spaced apart from the first bank pattern BP1 and be disposed on the right side, which is the other side of the center of the emission area EMA in the second direction DR2. The first bank patterns BP1 and the second bank patterns BP2 may be alternately disposed along the second direction DR2 and be disposed as island-shaped patterns in the display area DPA. The light emitting elements ED may be disposed between the first bank pattern BP1 and the second bank pattern BP2.

Lengths of the first bank pattern BP1 and the second bank pattern BP2 in the first direction DR1 may be the same as each other, but be smaller than a length, in the first direction DR1, of the emission area EMA surrounded by the lower bank layer LBN. The first bank pattern BP1 and the second bank pattern BP2 may be spaced apart from a portion of the lower bank layer LBN extending in the second direction DR2. However, embodiments are not limited thereto. For example, the bank patterns BP1 and BP2 and the lower bank layer LBN may be integral with each other. For example, the bank patterns BP1 and BP2 may partially overlap a portion of the lower bank layer LBN extending in the second direction DR2. For example, lengths of the bank patterns BP1 and BP2 in the first direction DR1 may be the same as or greater than a length, in the first direction DR1, of the emission area EMA surrounded by the lower bank layer LBN.

The first bank pattern BP1 and the second bank pattern BP2 may have the same width in the second direction DR2. However, embodiments are not limited thereto, and the first bank pattern BP1 and the second bank pattern BP2 may also have different widths. For example, any one bank pattern may have a greater width than the other bank pattern, and the bank pattern having the greater width may be disposed over the emission areas EMA of other sub-pixels SPXn adjacent to each other in the second direction DR2. For example, the second bank pattern BP2 of the bank patterns disposed over emission areas EMA may overlap a portion of the lower bank layer LBN extending in the first direction DR1 in the thickness direction. In the drawings, two bank patterns BP1 and BP2 are illustrated to have the same width are disposed for each sub-pixel SPXn, but embodiments are not limited thereto. The number and shape of bank patterns BP1 and BP2 may vary according to the number or arrangement structure of electrodes RME.

The bank patterns BP1 and BP2 may be disposed on the via layer VIA. For example, the bank patterns BP1 and BP2 may be directly disposed on the via layer VIA, and may have a structure in which at least portions thereof protrude on the basis of an upper surface of the via layer VIA. The protruding portions of the bank patterns BP1 and BP2 may have inclined or curved side surfaces, and light emitted from the light emitting elements ED may be reflected by the electrodes RME disposed on the bank patterns BP1 and BP2 and emitted in an upward direction of the via layer VIA. Unlike illustrated in the drawings, the bank patterns BP1 and BP2 may have a semi-circular or semi-elliptical shape with a curved outer surface in a cross-sectional view. The bank patterns BP1 and BP2 may include an organic insulating material such as polyimide (PI), but embodiments are not limited thereto.

The electrodes RME (e.g., RME1 and RME2) have a shape in which they extend in one direction, and are disposed for each sub-pixel SPXn. The electrodes RME1 and RME2 may extend in the first direction DR1 to be disposed in the emission area EMA and the sub-area SA of the sub-pixel SPXn, and may be spaced apart from each other in the second direction DR2. The electrodes RME may be connected to (e.g., electrically connected to) light emitting elements ED as described below, but embodiments are not limited thereto, and may not be electrically connected to the light emitting elements ED.

The display device 10 may include the first electrode RME1 and the second electrode RME2 disposed in each sub-pixel SPXn. The first electrode RME1 may be disposed on the left side of the center of the emission area EMA, and the second electrode RME2 is spaced apart from the first electrode RME1 in the second direction DR2 and disposed on the right side of the center of the emission area EMA. The first electrode RME1 may be disposed on the first bank pattern BP1, and the second electrode RME2 may be disposed on the second bank pattern BP2. The first electrode RME1 and the second electrode RME2 may be partially disposed in the corresponding sub-pixel SPXn and the sub-area SA beyond the lower bank layer LBN. The first electrodes RME1 and the second electrodes RME2 of different sub-pixels SPXn may be spaced apart from each other by the separation part ROP positioned in the sub-area SA of any one sub-pixel SPXn.

In the drawings, the two electrodes RME are illustrated to have a shape extending in the first direction DR1 for each sub-pixel SPXn, but embodiments are not limited thereto. For example, in the display device 10, the larger number of electrodes RME may be disposed in one sub-pixel SPXn or the electrodes RME may have a shape in which they are partially bent and have different widths according to positions thereof.

The first electrode RME1 and the second electrode RME2 may be disposed on at least the inclined side surfaces of the bank patterns BP1 and BP2, respectively. In an embodiment, a width of the electrodes RME in the second direction DR2 may be smaller than a width of the bank patterns BP1 and BP2 in the second direction DR2, and an interval (or gap) between the first electrode RME1 and the second electrode RME2 spaced apart from each other in the second direction DR2 may be smaller than an interval (or gap) between the bank patterns BP1 and BP2. At least partial areas of the first electrode RME1 and the second electrode RME2 may be directly disposed on the via layer VIA, such that the first electrode RME1 and the second electrode RME2 may be disposed on the same plane (e.g., an upper surface or a lateral surface of the via layer VIA).

The light emitting elements ED disposed between the bank patterns BP1 and BP2 may emit light toward both ends (e.g., opposite ends) thereof. The emitted light may be directed to the electrodes RME disposed on the bank patterns BP1 and BP2. The respective electrodes RME may have a structure which includes portions disposed on the bank patterns BP1 and BP2, and reflects the light emitted from the light emitting elements ED. The first electrode RME1 and the second electrode RME2 may cover at least one side surfaces of the bank patterns BP1 and BP2 to reflect the light emitted from the light emitting elements ED.

The respective electrodes RME may be in direct contact with the third conductive layer through the electrode contact holes CTD and CTS at portions of the respective electrodes RME, which overlap the lower bank layer LBN between the emission area EMA and the sub-area SA, e.g., in a plan view. A first electrode contact hole CTD may be formed in an area in which the lower bank layer LBN and the first electrode RME1 overlap each other, and a second electrode contact hole CTS may be formed in an area in which the lower bank layer LBN and the second electrode RME2 overlap each other. The first electrode RME1 may be in contact with (e.g., in electrical contact with) the first conductive pattern CDP through the first electrode contact hole CTD penetrating through the via layer VIA and the first passivation layer PV1. The second electrode RME2 may be in contact with (e.g., in electrical contact with) the second voltage line VL2 through the second electrode contact hole CTS penetrating through the via layer VIA and the first passivation layer PV1. The first electrode RME1 may be connected to (e.g., electrically connected to) the first transistor T1 through the first conductive pattern CDP1 to receive the first source voltage applied thereto, and the second electrode RME2 may be connected to (e.g., electrically connected to) the second voltage line VL2 to receive the second source voltage applied thereto. However, embodiments are not limited thereto. In an embodiment, the respective electrodes RME1 and RME2 may not be electrically connected to the voltage lines VL1 and VL2 of the third conductive layer, and connection electrodes CNE as described below may be connected to (e.g., directly connected to) the third conductive layer.

The electrodes RME may include a conductive material having high reflectivity. For example, the electrodes RME may include a metal such as silver (Ag), copper (Cu), or aluminium (Al), include an alloy including aluminium (Al), nickel (Ni), lanthanum (La), or the like, or have a structure in which a metal layer made of titanium (Ti), molybdenum (Mo), and niobium (Nb) and the alloy are stacked each other. In some embodiments, the electrodes RME may be formed as a double-layer or multiple layers in which an alloy including aluminium (Al) and one or more metal layers made of titanium (Ti), molybdenum (Mo), and niobium (Nb) are stacked each other.

Embodiments are not limited thereto, and each of the electrodes RME may further include a transparent conductive material. For example, each of the electrodes RME may include a material such as ITO, IZO, or ITZO. In some embodiments, each of the electrodes RME may have a structure in which one or more layers made of a transparent conductive material and one or more layers made of a metal having high reflectivity are stacked or may be formed as a single layer including the transparent conductive material and the metal having the high reflectivity. For example, each of the electrodes RME may have a stacked structure such as ITO/Ag/ITO, ITO/Ag/IZO, or ITO/Ag/ITZO/IZO. The electrodes RME may reflect some portion of the light emitted from the light emitting elements ED in an upward direction of the first substrate SUB with being connected to (e.g., electrically connected to) the light emitting elements ED.

A first insulating layer PAS1 may be disposed in the entirety of the display area DPA, and may be disposed on the via layer VIA and the electrodes RME. The first insulating layer PAS1 may insulate different electrodes RME from each other and may also protect the plurality of electrodes RME. For example, the first insulating layer PAS1 may cover the electrodes RME before the lower bank layer LBN is formed, and may thus prevent the electrodes RME from being damaged in a process of forming the lower bank layer LBN. For example, the first insulating layer PAS1 may prevent the light emitting elements ED disposed on the first insulating layer PAS1 from being in direct contact with and being damaged by other members.

In an embodiment, the first insulating layer PAS1 may have a step (e.g., a recessed portion) so that a portion of an upper surface thereof is recessed between the electrodes RME spaced apart from each other in the second direction DR2. The light emitting elements ED may be disposed on the upper surface of the first insulating layer PAS1 in which the step (e.g., a recessed portion) is formed, and a space may be formed between the light emitting elements ED and the first insulating layer PAS1.

The lower bank layer LBN may be disposed on the first insulating layer PAS1. The lower bank layer LBN may include portions extending in the first direction DR1 and the second direction DR2, and surround each of the sub-pixels SPXn. The lower bank layer LBN may divide the emission area EMA and the sub-area SA of each sub-pixel SPXn by surrounding the emission area EMA and the sub-area SA of each sub-pixel SPXn, and may divide the display area DPA and the non-display area NDA by surrounding the outermost portion of the display area DPA. The lower bank layer LBN may be substantially entirely (or partially) disposed in the display area DPA to form a lattice-shape pattern, and an area opened by the lower bank layer LBN in the display area DPA may be the emission area EMA and the sub-area SA.

The lower bank layer LBN may have a height (e.g., as predetermined), similar to the bank patterns BP1 and BP2. In some embodiments, a height of an upper surface of the lower bank layer LBN may be greater than that of the bank patterns BP1 and BP2, and a thickness of the lower bank layer LBN may be the same as or greater than that of the bank patterns BP1 and BP2, e.g., in the third direction DR3. The lower bank layer LBN may prevent ink from overflowing into adjacent sub-pixels SPXn in an inkjet printing process of processes of manufacturing the display device 10. The lower bank layer LBN may include an organic insulating material such as polyimide like, which is included in the bank patterns BP1 and BP2.

The light emitting elements ED may be disposed in the emission area EMA. The light emitting elements ED may be disposed between the bank patterns BP1 and BP2, in the second direction DR2. The light emitting elements ED may be arranged to be spaced apart from each other in the first direction DR1. In an embodiment, the light emitting elements ED may have a shape extending in a direction, and have both ends each disposed on different electrodes RME (e.g., RME1 and RME2). The light emitting elements ED may have a length greater than the interval (or gap) between the electrodes RME spaced apart from each other in the second direction DR2. The light emitting elements ED may be arranged so that an extension direction of the light emitting elements ED is substantially perpendicular to the first direction DR1 in which the electrodes RME extend. However, embodiments are not limited thereto. For example, the light emitting elements ED may be disposed so that the extension direction of the light emitting elements ED is the second direction DR2 or a direction obliquely inclined with respect to the second direction DR2.

The light emitting elements ED may be disposed on the first insulating layer PAS1. The light emitting element ED may have a shape extending in a direction, and may be disposed such that the extension direction is substantially parallel to an upper surface of the first substrate SUB. As described below, the light emitting element ED may include semiconductor layers disposed along a direction in which it extends, and the semiconductor layers may be sequentially disposed along a direction substantially parallel to the upper surface of the first substrate SUB. However, embodiments are not limited thereto, and in case that the light emitting element ED has another structure, the semiconductor layers may also be disposed in a direction perpendicular to the first substrate SUB.

The light emitting elements ED disposed in each sub-pixel SPXn may emit light of different wavelength bands according to materials of the above-described semiconductor layers. However, embodiments are not limited thereto, and the light emitting elements ED disposed in each sub-pixel SPXn may include semiconductor layers made of the same material to emit light of the same color.

The light emitting elements ED may be in contact with (e.g., in electrical contact with) the connection electrodes CNE (e.g., CNE1 and CNE2) to be connected to (e.g., electrically connected to) the electrodes RME and the conductive layers below the via layer VIA, and may receive electrical signals applied thereto to emit light of a specific wavelength band.

A second insulating layer PAS2 may be disposed on the light emitting elements ED, the first insulating layer PAS1, and the lower bank layer LBN. The second insulating layer PAS2 may include a pattern part extending in the first direction DR1 between the bank patterns BP1 and BP2 and disposed on the light emitting elements ED. The pattern part may partially (or entirely) surround outer surfaces of the light emitting elements ED, and may not cover both sides or both ends of the light emitting elements ED. The pattern part may form a linear or island-shaped pattern in each sub-pixel SPXn in a plan view. The pattern part of the second insulating layer PAS2 may protect the light emitting elements ED and simultaneously fix the light emitting elements ED during the manufacturing process of the display device 10. For example, the second insulating layer PAS2 may fill spaces between the light emitting elements ED and the first insulating layer PAS1 below the light emitting elements ED. For example, a portion of the second insulating layer PAS2 may be disposed on the lower bank layer LBN and in the sub-areas SA.

The connection electrodes CNE (e.g., CNE1 and CNE2) may be disposed on the electrodes RME and the bank patterns BP1 and BP2. The connection electrodes CNE may each have a shape extending in a direction, and may be spaced apart from each other. Each of the connection electrodes CNE may be in contact with (e.g., in electrical contact with) the light emitting elements ED and be connected to (e.g., electrically connected to) the third conductive layer.

The connection electrodes CNE may include a first connection electrode CNE1 and a second connection electrode CNE2 disposed in each sub-pixel SPXn. The first connection electrode CNE1 may have a shape extending in the first direction DR1, and may be disposed on the first electrode RME1 or the first bank pattern BP1. The first connection electrode CNE1 may partially overlap the first electrode RME1, and may be disposed from the emission area EMA to the sub-area SA beyond the lower bank layer LBN. The second connection electrode CNE2 may have a shape extending in the first direction DR1, and may be disposed on the second electrode RME2 or the second bank pattern BP2. The second connection electrode CNE2 may partially overlap the second electrode RME2, and may be disposed from the emission area EMA to the sub-area SA beyond the lower bank layer LBN. The first connection electrode CNE1 and the second connection electrode CNE2 may be in contact with (e.g., in electrical contact with) the light emitting elements ED, respectively, and may be connected to (e.g., electrically connected to) the electrodes RME or the conductive layer below the electrodes RME.

For example, the first connection electrode CNE1 and the second connection electrode CNE2 may be disposed on side surfaces of the second insulating layer PAS2, respectively, and may be in contact with (e.g., in electrical contact with) the light emitting elements ED. The first connection electrode CNE1 may partially overlap the first electrode RME1, and may be in contact with (e.g., in electrical contact with) an end of the light emitting elements ED. The second connection electrode CNE2 may partially overlap the second electrode RME2, and may be in contact with (e.g., in electrical contact with) the other ends of the light emitting elements ED. The connection electrodes CNE are disposed over the emission area EMA and the sub-area SA. The connection electrodes CNE may be in contact with (e.g., in electrical contact with) the light emitting elements ED at portions thereof disposed in the emission area EMA, and may be connected to (e.g., electrically connected to) the third conductive layer at portions thereof disposed in the sub-area SA.

According to an embodiment, in the display device 10, the respective connection electrodes CNE may be in contact with (e.g., in electrical contact with) the electrodes RME through the contact parts CT1 and CT2 disposed in the sub-area SA The first connection electrode CNE1 may be in contact with (e.g., in electrical contact with) the first electrode RME1 through a first contact part CT1 penetrating through the first insulating layer PAS1, the second insulating layer PAS2, and a third insulating layer PAS3 in the sub-area SA. The second connection electrode CNE2 may be in contact with (e.g., in electrical contact with) the second electrode RME2 through a second contact part CT2 penetrating through the first insulating layer PAS1 and the second insulating layer PAS2 in the sub-area SA. The respective connection electrodes CNE may be connected to (e.g., electrically connected to) the third conductive layer through the respective electrodes RME. The first connection electrode CNE1 may be connected to (e.g., electrically connected to) the first transistor T1 to receive the first source voltage applied thereto, and the second connection electrode CNE2 may be connected to (e.g., electrically connected to) the second voltage line VL2 to receive the second source voltage applied thereto. The respective connection electrodes CNE may be in contact with (e.g., in electrical contact with) the light emitting elements ED in the emission area EMA to transfer the source voltages to the light emitting elements ED.

However, embodiments are not limited thereto. In some embodiments, the connection electrodes CNE may be in direct contact with the third conductive layer, or may be connected to (e.g., electrically connected to) the third conductive layer through other patterns rather than the electrodes RME.

The connection electrodes CNE may include a conductive material. For example, the connection electrodes CNE may include ITO, IZO, ITZO, aluminium (Al), or the like. As an example, the connection electrodes CNE may include a transparent conductive material, and the light emitted from the light emitting elements ED may be transmitted through the connection electrodes CNE and emitted.

The third insulating layer PAS3 may be disposed on the second connection electrode CNE2 and the second insulating layer PAS2. The third insulating layer PAS3 may be entirely disposed on the second insulating layer PAS2 so as to cover the second connection electrode CNE2, and the first connection electrode CNE1 may be disposed on the third insulating layer PAS3. The third insulating layer PAS3 may be entirely disposed on the via layer VIA except for an area in which the first connection electrode CNE1 is disposed. The third insulating layer PAS3 may insulate the first connection electrode CNE1 and the second connection electrode CNE2 from each other so that the first connection electrode CNE1 is not in direct contact with the second connection electrode CNE2.

For example, another insulating layer may be further disposed on the third insulating layer PAS3 and the first connection electrode CNE1. Such an insulating layer may serve (or function) to protect members disposed on the first substrate SUB from an external environment.

Each of the first insulating layer PAS1, the second insulating layer PAS2, and the third insulating layer PAS3 described above may include an inorganic insulating material or an organic insulating material. As an example, each of the first insulating layer PAS1, the second insulating layer PAS2, and the third insulating layer PAS3 may include an inorganic insulating material, or the first insulating layer PAS1 and the third insulating layer PAS3 may include an inorganic insulating material, but the second insulating layer PAS2 may include an organic insulating material. Each or at least one of the first insulating layer PAS1, the second insulating layer PAS2, and the third insulating layer PAS3 may be formed in a structure in which insulating layers are alternately or repeatedly stacked each other. In an embodiment, each of the first insulating layer PAS1, the second insulating layer PAS2, and the third insulating layer PAS3 may be made of any one of silicon oxide (SiOₓ), silicon nitride (SiNₓ), and silicon oxynitride (SiOₓN_{y}). All of the first insulating layer PAS1, the second insulating layer PAS2, and the third insulating layer PAS3 may be made of the same material, some of the first insulating layer PAS1, the second insulating layer PAS2, and the third insulating layer PAS3 may be made of the same material and the others may be made of a different material, or all of the first insulating layer PAS1, the second insulating layer PAS2, and the third insulating layer PAS3 may be made of different materials.

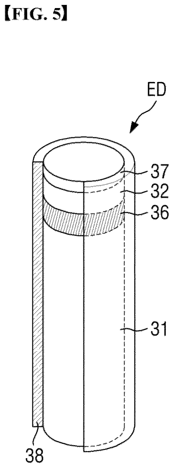

FIG. 5 is a schematic view of a light emitting element according to an embodiment.

Referring to FIG. 5, the light emitting element ED may be a light emitting diode. Specifically, the light emitting element ED may be an inorganic light emitting diode having a size of a nanometer to a micrometer scale and made of an inorganic material. The light emitting element ED may be aligned between two electrodes in which polarities are formed in case that an electric field is formed in a specific direction between the two electrodes facing each other.

The light emitting element ED according to an embodiment may have a shape extending in a direction. The light emitting element ED may have a shape such as a cylindrical shape, a rod shape, a wire shape, or a tube shape. However, the light emitting element ED is not limited to having the shape described above, and may have various shapes. For example, the light emitting element ED may have a polygonal prismatic shape such as a cubic shape, a rectangular parallelepiped shape, or a hexagonal prismatic shape or have a shape extending in a direction but has partially inclined outer surfaces.

The light emitting element ED may include a semiconductor layer doped with any conductivity-type (e.g., p-type or n-type) dopant. The semiconductor layer may receive an electrical signal applied from an external power source to emit light of a specific wavelength band. The light emitting element ED may include a first semiconductor layer 31, a second semiconductor layer 32, a light emitting layer 36, an electrode layer 37, and an insulating film 38.

The first semiconductor layer 31 may be an n-type semiconductor. The first semiconductor layer 31 may include a semiconductor material having a chemical formula of AlₓGa_{y}In_{1-x-y}N (0 ≤ x ≤ 1, 0 ≤ y ≤ 1, and 0 ≤ x + y ≤ 1). For example, the semiconductor material of the first semiconductor layer 31 may be one or more of AlGaInN, GaN, AlGaN, InGaN, AIN, and InN doped with an n-type dopant. The n-type dopant doped in the first semiconductor layer 31 may be Si, Ge, Sn, or the like.

The second semiconductor layer 32 may be disposed on the first semiconductor layer 31 with the light emitting layer 36 interposed therebetween. The second semiconductor layer 32 may be a p-type semiconductor, and may include a semiconductor material having a chemical formula of AlₓGa_{y}In_{1-x-y}N (0 ≤ x ≤ 1, 0 ≤ y ≤ 1, and 0 ≤ x + y ≤ 1). For example, the semiconductor material of the second semiconductor layer 32 may be one or more of AlGaInN, GaN, AlGaN, InGaN, AIN, and InN doped with a p-type dopant. The p-type dopant doped in the second semiconductor layer 32 may be Mg, Zn, Ca, Ba, or the like.

FIG. 5 illustrates that each of the first semiconductor layer 31 and the second semiconductor layer 32 is configured as a single layer, but embodiments are not limited thereto. Each of the first semiconductor layer 31 and the second semiconductor layer 32 may further include the larger number of layers, for example, a clad layer or a tensile strain barrier reducing (TSBR) layer, according to a material of the light emitting layer 36. For example, the light emitting element ED may further include another semiconductor layer disposed between the first semiconductor layer 31 and the light emitting layer 36 or between the second semiconductor layer 32 and the light emitting layer 36. The semiconductor layer disposed between the first semiconductor layer 31 and the light emitting layer 36 may be made of one or more of AlGaInN, GaN, AlGaN, InGaN, AIN, InN, and SLs doped with an n-type dopant, and the semiconductor layer disposed between the second semiconductor layer 32 and the light emitting layer 36 may be made of one or more of AlGaInN, GaN, AlGaN, InGaN, AIN, and InN doped with a p-type dopant.

The light emitting layer 36 may be disposed between the first semiconductor layer 31 and the second semiconductor layer 32. The light emitting layer 36 may include a material having a single or multiple quantum well structure. In case that the light emitting layer 36 includes the material having the multiple quantum well structure, the light emitting layer 36 may have a structure in which barrier layers and well layers are alternately stacked each other. The light emitting layer 36 may emit light by a combination of electron-hole pairs according to electrical signals applied through the first semiconductor layer 31 and the second semiconductor layer 32. The light emitting layer 36 may include a material such as AlGaN, AlGaInN, or InGaN. In case that the light emitting layer 36 has the multiple quantum well structure, e.g., the structure in which the barrier layers and the well layers are alternately stacked each other, the barrier layers may include a material such as AlGaN or AlGaInN, and the well layers may include a material such as GaN, InGaN, or AllnN.

The light emitting layer 36 may have a structure in which semiconductor materials having large band gap energy and semiconductor materials having small band gap energy are alternately stacked each other, and may include other Group III to Group V semiconductor materials according to a wavelength band of emitted light. The light emitted by the light emitting layer 36 is not limited to light of a blue wavelength band, and in some cases, the light emitting layer 36 may also emit light of red and green wavelength bands.

The electrode layer 37 may be an ohmic connection electrode. However, embodiments are not limited thereto, and the electrode layer 37 may also be a Schottky connection electrode. The light emitting element ED may include at least one electrode layer 37. The light emitting element ED may include one or more electrode layers 37, but embodiments are not limited thereto, and the electrode layers 37 may also be omitted.

The electrode layer 37 may decrease resistance between the light emitting element ED and the electrode or the connection electrode in case that the light emitting element ED is connected to (e.g., electrically connected to) the electrode or the connection electrode in the display device 10. The electrode layer 37 may include a metal having conductivity. The electrode layer 37 may include at least one of aluminium (Al), titanium (Ti), indium (In), gold (Au), silver (Ag), ITO, IZO, and ITZO.

The insulating film 38 may surround outer surfaces of the semiconductor layers and the electrode layer described above. For example, the insulating film 38 may surround at least an outer surface of the light emitting layer 36, but may be formed to expose both ends of the light emitting element ED in a length direction. For example, the insulating film 38 may also include an upper surface rounded in a cross section and adjacent to at least one end of the light emitting element ED.

The insulating film 38 may include materials having insulating properties, such as silicon oxide (SiOₓ), silicon nitride (SiNₓ), silicon oxynitride (SiOₓN_{y}), aluminium nitride (AlNₓ), and aluminium oxide (AlOₓ). FIG. 5 illustrates that the insulating film 38 is formed as a single layer, but embodiments are not limited thereto, and in some embodiments, the insulating film 38 may also be formed in a multilayer structure in which layers are stacked each other.

The insulating film 38 may serve (or function) to protect the semiconductor layers and the electrode layer of the light emitting element ED. The insulating film 38 may prevent an electrical short circuit that may occur in the light emitting layer 36 in case that the light emitting layer 36 is in direct contact with an electrode through which an electrical signal is transferred to the light emitting element ED. For example, the insulating film 38 may prevent a decrease in luminous efficiency of the light emitting element ED.

For example, an outer surface of the insulating film 38 may be formed by a surface treatment. The light emitting elements ED may be sprayed or injected onto and be aligned on electrodes in a state in which they are dispersed in ink (e.g., as predetermined). Here, in order to maintain the light emitting elements ED in a state in which the light emitting elements ED are dispersed without being agglomerated with other adjacent light emitting elements ED in the ink, a hydrophobic or hydrophilic treatment may be performed on a surface of the insulating film 38.

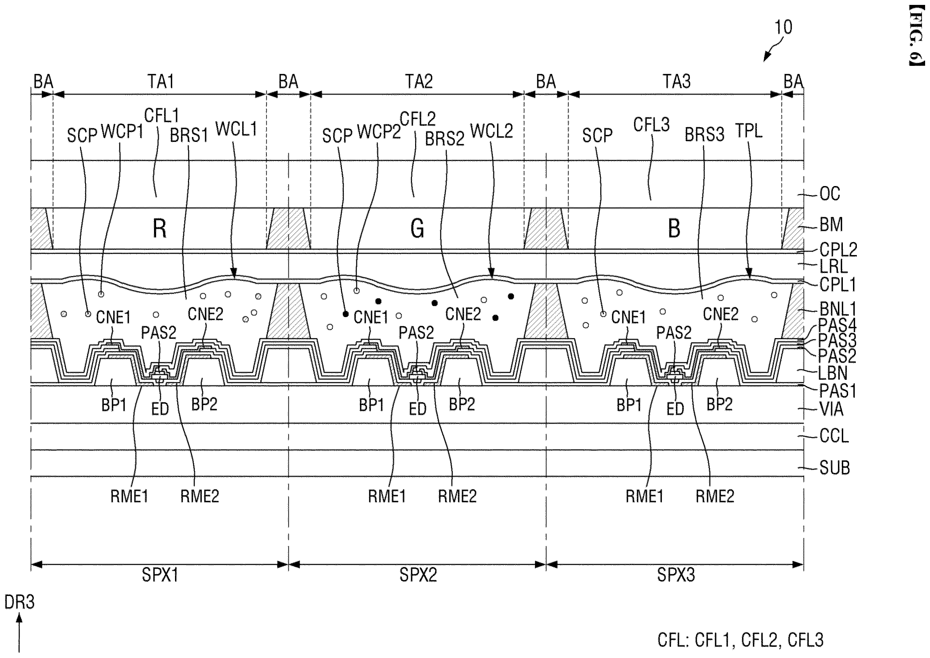

According to an embodiment, the display device 10 may further include color control members TPL, WCL1, and WCL2 (see FIG. 6) and color filter layers CFL1, CFL2, and CFL3 (see FIG. 6) disposed on the light emitting elements ED. The light emitted from the light emitting elements ED may be emitted through the color control members TPL, WCL1, and WCL2 and the color filter layers CFL1, CFL2, and CFL3, and even though the same type of light emitting elements ED are disposed for each sub-pixel SPXn, colors of the emitted light may be different for each sub-pixel SPXn.

FIG. 6 is a schematic cross-sectional view of the display device according to an embodiment.

Referring to FIG. 6, the display device 10 may include the light emitting elements ED disposed on the first substrate SUB, and the color control members TPL, WCL1, and WCL2 and the color filter layers CFL1, CFL2, and CFL3 disposed on the light emitting elements ED. For example, the display device 10 may further include layers disposed between the color control members TPL, WCL1, and WCL2 and the color filter layers CFL1, CFL2, and CFL3. Hereinafter, layers disposed on the light emitting elements ED of the display device 10 will be described for descriptive convenience.

A fourth insulating layer PAS4 may be disposed on the third insulating layer PAS3, the connection electrodes CNE1 and CNE2, and the lower bank layer LBN. The fourth insulating layer PAS4 may protect layers disposed on the first substrate SUB. However, the fourth insulating layer PAS4 may be omitted.

A first bank BNL1, the color control members TPL, WCL1, and WCL2, a light blocking member BM, and the color filter layers CFL1, CFL2, and CFL3 may be disposed on the fourth insulating layer PAS4. For example, capping layers CPL1 and CPL2 and a low refraction layer LRL may be disposed between the color control members TPL, WCL1, and WCL2 and the color filter layers CFL1, CFL2, and CFL3, and an overcoat layer OC may be disposed on the color filter layers CFL1, CFL2, and CFL3.

The display device 10 may include light transmitting areas TA1, TA2, and TA3 in which the color filter layers CFL1, CFL2, and CFL3 are disposed and the light is emitted and light blocking areas BA which is disposed between the light transmitting areas TA1, TA2, and TA3 and in which the light is not emitted. The light transmitting areas TA1, TA2, and TA3 may be positioned to correspond to portions of the emission areas EMA of each sub-pixel SPXn, and the light blocking areas BA may be areas other than the light transmitting areas TA1, TA2 and TA3. As described below, the light transmitting areas TA1, TA2, and TA3 and the light blocking areas BA may be divided by the light blocking member BM.

The first bank BNL1 may be disposed on the fourth insulating layer PAS4 so as to overlap the lower bank layer LBN. The first bank BNL1 may be disposed in a lattice pattern by including portions extending in the first direction DR1 and the second direction DR2. The first bank BNL1 may surround the emission areas EMA or portions in which the light emitting elements ED are disposed. The first bank BNL1 may form areas in which the color control members TPL, WCL1, and WCL2 are disposed.

The color control members TPL, WCL1, and WCL2 may be disposed in areas surrounded by the first bank BNL1 on the fourth insulating layer PAS4. The color control members TPL, WCL1, and WCL2 may be disposed, respectively, in the light transmitting areas TA1, TA2, and TA3 surrounded by the first bank BNL1 to form island-shaped patterns in the display area DPA. However, embodiments are not limited thereto, and the color control members TPL, WCL1 and WCL2 may also extend in a direction and be disposed over the sub-pixels SPXn to form linear patterns.

In an embodiment in which the light emitting elements ED of each sub-pixel SPXn emit blue light of a third color, the color control members TPL, WCL1, and WCL2 may include a first wavelength conversion layer WCL1 disposed in (or on) the first sub-pixel SPX1 so as to correspond to a first light transmitting area TA1, a second wavelength conversion layer WCL2 disposed in (or on) the second sub-pixel SPX2 so as to correspond to a second light transmitting area TA2, and a light transmitting layer TPL disposed in the third sub-pixel SPX3 so as to correspond to a third light transmitting area TA3.

The first wavelength conversion layer WCL1 may include a first base resin BRS1 and first wavelength conversion materials WCP1 disposed in the first base resin BRS1. The second wavelength conversion layer WCL2 may include a second base resin BRS2 and second wavelength conversion materials WCP2 disposed in the second base resin BRS2. The first wavelength conversion layer WCL1 and the second wavelength conversion layer WCL2 may convert a wavelength of the blue light of the third color incident from the light emitting elements ED and transmit the light having the converted wavelength therethrough. The first wavelength conversion layer WCL1 and the second wavelength conversion layer WCL2 may further include scatterers SCP included in each base resin, and the scatterers SCP may increase wavelength conversion efficiency.

The light transmitting layer TPL may include a third base resin BRS3 and scatterers SCP disposed in the third base resin BSR3. The light transmitting layer TPL transmits the blue light of the third color incident from the light emitting elements ED therethrough with maintaining the wavelength of the blue light of the third color. The scatterers SCP of the light transmitting layer TPL may serve (or function) to adjust an emission path of the light emitted through the light transmitting layer TPL. The light transmitting layer TPL may not include wavelength conversion materials.

The scatterers SCP may be metal oxide particles or organic particles. Examples of metal oxide of the metal oxide particle may include titanium oxide (TiO₂), zirconium oxide (ZrO₂), aluminium oxide (Al₂O₃), indium oxide (In₂O₃), zinc oxide (ZnO), tin oxide (SnO₂), or the like, and examples of a material of the organic particle may include an acrylic resin, a urethane resin, or the like.

The first to third base resins BRS1, BRS2, and BRS3 may include a light transmitting organic material. For example, the first to third base resins BRS1, BRS2, and BRS3 may include an epoxy-based resin, an acrylic resin, a cardo-based resin, an imide-based resin, or the like. All of the first to third base resins BRS1, BRS2, and BRS3 may be made of the same material, but embodiments are not limited thereto.

The first wavelength conversion material WCP1 may be a material converting the blue light of the third color into red light of a first color, and the second wavelength conversion material WCP2 may be a material converting the blue light of the third color into green light of a second color. The first wavelength conversion material WCP1 and the second wavelength conversion material WCP2 may be quantum dots, quantum rods, phosphors, or the like. The quantum dot may include group IV nanocrystals, group II-VI compound nanocrystals, group III-V compound nanocrystals, group IV-VI compound nanocrystals, or combinations thereof.

In some embodiments, the color control members TPL, WCL1, and WCL2 may be formed through an inkjet printing process or a photoresist process. The color control members TPL, WCL1, and WCL2 may be formed by jetting or applying a material forming the color control members TPL, WCL1, and WCL2 in the areas surrounded by the first bank BNL1 and performing drying or exposing and developing processes. As an example, in an embodiment in which the color control members TPL, WCL1, and WCL2 are formed by the inkjet printing process, in FIG. 6, upper surfaces of respective layers of the color control members TPL, WCL1, and WCL2 may be formed to be curved, such that edge portions of the color control members TPL, WCL1, and WCL2 adjacent to the first bank BNL1 may be higher than central portions thereof. However, embodiments are not limited thereto. In an embodiment in which the color control members TPL, WCL1, and WCL2 are formed by the photoresist process, upper surfaces of respective layers of the color control members TPL, WCL1, and WCL2 may be formed to be flat, such that edge portions of the color control members TPL, WCL1, and WCL2 adjacent to the first bank BNL1 may be substantially parallel to an upper surface of the first bank BNL1, or central portions of the color control members TPL, WCL1, and WCL2 may be higher than edge portions thereof unlike FIG. 6.

The light emitting elements ED of each sub-pixel SPXn may emit the blue light of the same third color, and the light emitted from each sub-pixel SPXn may be light of different colors. For example, the light emitted from the light emitting elements ED disposed in the first sub-pixel SPX1 is incident on the first wavelength conversion layer WCL1, the light emitted from the light emitting elements ED disposed in the second sub-pixel SPX2 is incident on the second wavelength conversion layer WCL2, and the light emitted from the light emitting elements ED disposed in the third sub-pixel SPX3 is incident on the light transmitting layer TPL. The light incident on the first wavelength conversion layer WCL1 may be converted into the red light, the light incident on the second wavelength conversion layer WCL2 may be converted into the green light, and the light incident on the light transmitting layer TPL may be transmitted as the same blue light without wavelength conversion. Even though the respective sub-pixels SPXn include the light emitting elements EL emitting the light of the same color, the respective sub-pixels SPXn may emit light of different colors according to an arrangement of the color control members TPL, WCL1, and WCL2 disposed above the light emitting elements EL.

A first capping layer CPL1 may be disposed on color control members TPL, WCL1, and WCL2 and the first bank BNL1. The first capping layer CPL1 may prevent impurities such as moisture or air from permeating from the outside to damage or contaminate the color control members TPL, WCL1, and WCL2. The first capping layer CPL1 may include an inorganic insulating material.

The low refraction layer LRL may be disposed on the first capping layer CPL1. The low refraction layer LRL may be an optical layer recycling light passing through the color control members TPL, WCL1, and WCL2, and may improve light emission efficiency and color purity of the display device 10. The low refraction layer LRL may be made of an organic material having a low refractive index, and may compensate for a step formed by the color control members TPL, WCL1 and WCL2 and the first bank BLN1.

A second capping layer CPL2 may be disposed on the low refraction layer LRL, and may prevent impurities such as moisture or air from permeating from the outside to damage or contaminate the low refraction layer LRL. The second capping layer CPL2 may include an inorganic insulating material, similar to the first capping layer CPL1.

The light blocking member BM may be disposed on the second capping layer CPL2. The light blocking member BM may be formed in a lattice-shaped pattern so as to partially expose a surface of the second capping layer CPL2. In the display device 10, the light blocking member BM may cover the sub-areas SA of the respective sub-pixels SPXn in addition to the lower bank layer LBN and the first bank BNL1 in a plan view. Areas in which the light blocking member BM is not disposed may be the light transmitting areas TA1, TA2 and TA3 in which the color filter layers CFL1, CFL2, and CFL3 are disposed and the light is emitted, and areas in which the light blocking member BM is disposed may be the light blocking areas BA in which the emission of the light is blocked.

The light blocking member BM may include an organic material capable of absorbing (or blocking) the light. The light blocking member BM may reduce distortion of colors due to reflection of external light by absorbing the external light. For example, the light blocking member BM may be made of a material used as a black matrix of the display device 10, and may absorb all of visible light wavelengths.

In some embodiments, in the display device 10, the light blocking member BM may be omitted, and may be replaced with a material absorbing light of a specific wavelength of visible light wavelengths and transmitting light of another specific wavelength. The light blocking member BM may be replaced with a color pattern including the same material as at least one of the color filter layers CFL1, CFL2, and CFL3. For example, a color pattern including a material of any one color filter layer may be disposed or color patterns may be stacked each other, in the areas in which the light blocking member BM is disposed.

Color filter layers CFL1, CFL2, and CFL3 may be disposed on a surface (e.g., an upper surface) of the second capping layer CPL2. The color filter layers CFL1, CFL2, and CFL3 may be disposed on the second capping layer CPL2 so as to correspond to areas opened by the light blocking member BM. Different color filter layers CFL1, CFL2, and CFL3 may be spaced apart from each other with the light blocking member BM interposed therebetween, but embodiments are not limited thereto. In some embodiments, the color filter layers CFL1, CFL2, and CFL3 may be partially disposed on the light blocking member BM to be spaced apart from each other on the light blocking member BM, and in an embodiment, the color filter layers CFL1, CFL2, and CFL3 may partially overlap each other, e.g., in a plan view.

The color filter layers CFL1, CFL2, and CFL3 may include a first color filter layer CFL1 disposed in the first sub-pixel SPX1, a second color filter layer CFL2 disposed in the second sub-pixel SPX2, and a third color filter layer CFL3 disposed in the third sub-pixel SPX3. The color filter layers CFL1, CFL2, and CFL3 may be formed in linear patterns disposed in the light transmitting areas TA1, TA2, and TA3 or the emission areas EMA. However, embodiments are not limited thereto. The color filter layers CFL1, CFL2, and CFL3 may also be disposed to correspond to each of the light transmitting areas TA1, TA2, and TA3 and may be arranged in island-shape patterns.

The color filter layers CFL1, CFL2, and CFL3 may include colorants such as dyes or pigments absorbing light of wavelength bands other than light of a specific wavelength band. The color filter layers CFL1, CFL2, and CFL3 may be disposed for each sub-pixel SPXn and transmit some portion of light incident on the color filter layers CFL1, CFL2, and CFL3 in the corresponding sub-pixels SPXn. In each sub-pixel SPXn of the display device 10, only light transmitted through the color filter layers CFL1, CFL2, and CFL3 may be selectively displayed. In an embodiment, the first color filter layer CFL1 may be a red color filter layer, the second color filter layer CFL2 may be a green color filter layer, and the third color filter layer CFL3 may be a blue color filter layer. The light emitted from the light emitting elements ED may pass through the color control members TPL, WCL1, and WCL2 and may be emitted through the color filter layers CFL1, CFL2, and CFL3.

The overcoat layer OC may be disposed on the color filter layers CFL1, CFL2, and CFL3 and the light blocking member BM. The overcoat layer OC may be disposed over the entirety of the display area DPA, and a portion of the overcoat layer OC may also be disposed in the non-display area NDA. The overcoat layer OC may include an organic insulating material to protect members disposed in the display area DPA from the outside.

The display device 10 according to an embodiment may include the color control members TPL, WCL1, and WCL2 and the color filter layers CFL1, CFL2, and CFL3 disposed above the light emitting elements ED to display the light of the different colors even though the same type of light emitting elements ED are disposed for each sub-pixel SPXn.

For example, the light emitting elements ED disposed in the first sub-pixel SPX1 may emit the blue light of the third color, and the blue light may pass through the fourth insulating layer PAS4 and may be incident on the first wavelength conversion layer WCL1. The first base resin BRS1 of the first wavelength conversion layer WCL1 may be made of a transparent material, and some portion of the light may be transmitted through the first base resin BRS1 and may be incident on the first capping layer CPL1 disposed on the first base resin BRS1. However, at least some portion of the light may be incident on the scatterers SCP and the first wavelength conversion materials WCP1 disposed in the first base resin BRS1, be scattered and wavelength-converted, and may be incident on the first capping layer CPL1 as the red light. The light incident on the first capping layer CPL1 may pass through the low refraction layer LRL and the second capping layer CPL2 and may be incident to the first color filter layer CFL1, and the first color filter layer CFL1 may block transmission of light other than the red light. Accordingly, the red light may be emitted from the first sub-pixel SPX1.

Similarly, the light emitted from the light emitting elements ED disposed in the second sub-pixel SPX2 may pass through the fourth insulating layer PAS4, the second wavelength conversion layer WCL2, the first capping layer CPL1, the low refraction layer LRL, the second capping layer CPL2, and the second color filter layer CFL2, and may be the green light.

The light emitting elements ED disposed in the third sub-pixel SPX3 may emit the blue light of the third color, and the blue light may pass through the fourth insulating layer PAS4 and may be incident on the light transmitting layer. The third base resin BRS3 of the light transmitting layer TPL may be made of a transparent material, and some portion of the light may be transmitted through the third base resin BRS3 and may be incident on the first capping layer CPL1 disposed on the third base resin BRS3. The light incident on the first capping layer CPL1 may pass through the low refraction layer LRL and the second capping layer CPL2 and may be incident to the third color filter layer CFL3, and the third color filter layer CFL3 may block transmission of light other than the blue light. Accordingly, the blue light may be emitted from the third sub-pixel SPX3.

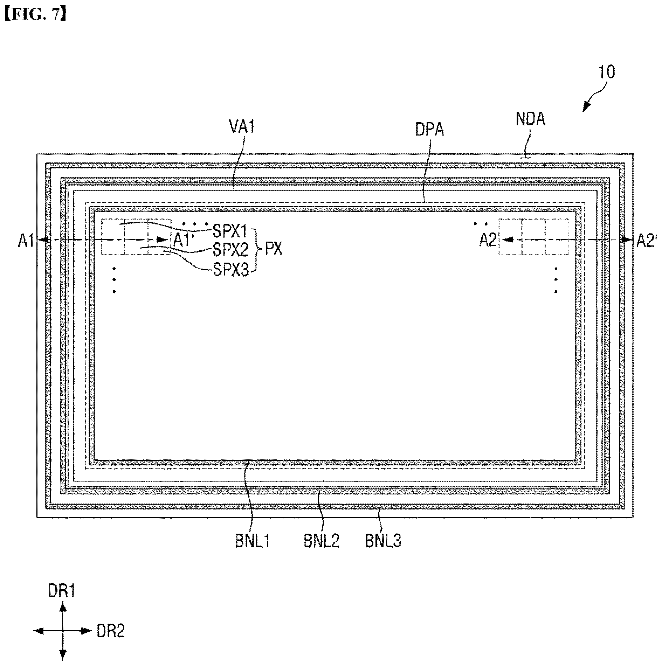

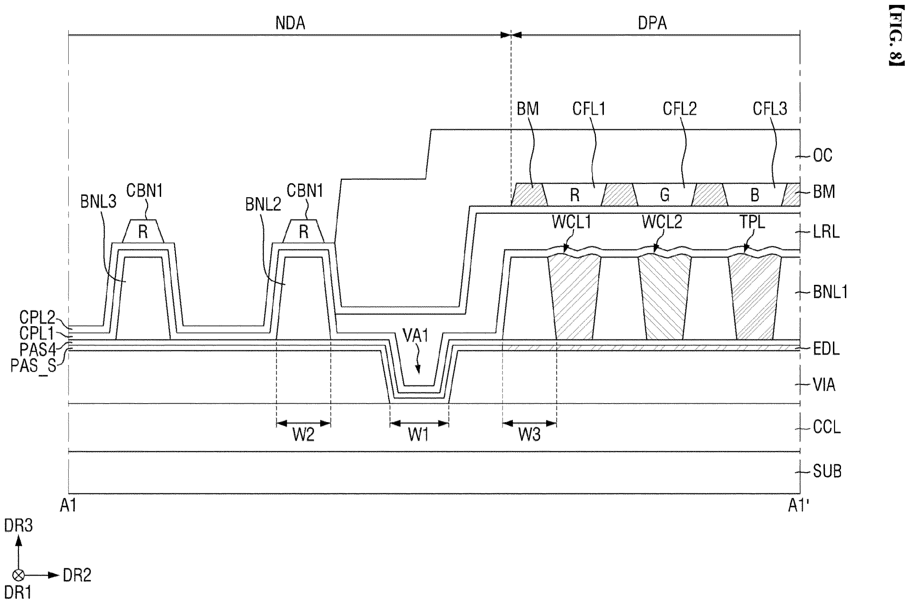

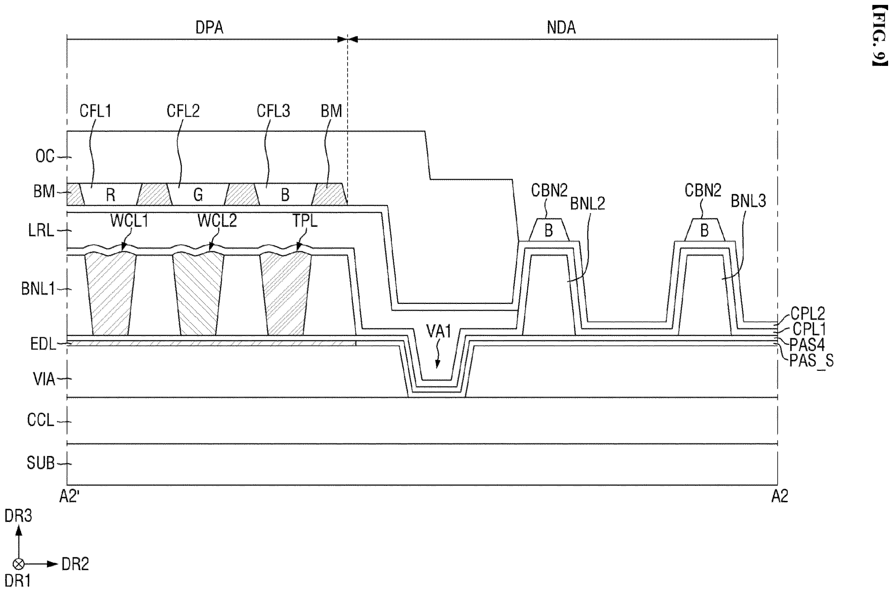

FIG. 7 is a schematic view illustrating banks disposed in a display area and a non-display area of the display device according to an embodiment. FIG. 8 is a schematic cross-sectional view taken along line A1-A1' of FIG. 7. FIG. 9 is a schematic cross-sectional view taken along line A2-A2' of FIG. 7. FIG. 7 illustrates a layout, in a plan view, of banks BNL1, BNL2, and BNL3 disposed in the display area DPA and the non-display area NDA of the display device 10.

FIGS. 8 and 9 illustrate cross sections of portions of the display area DPA and the non-display area NDA cut in the second direction DR2 at outer portions of the display device 10. FIG. 8 illustrates a left outer portion, which is one side in the second direction DR2, of the outer portions of the display device 10, and FIG. 9 illustrates a right outer portion, which is another side in the second direction DR2, of the outer portions of the display device 10. In FIGS. 8 and 9, the conductive layers and the semiconductor layer of the display area DPA have been briefly illustrated as a circuit layer CCL, and the electrodes RME, the light emitting elements ED, and the connection electrodes CNE disposed in the respective sub-pixels SPXn have been briefly illustrated as a light emitting element layer EDL. A description of these structures is the same as described above with reference to FIGS. 2 to 4.

Referring to FIGS. 7 to 9 in conjunction with FIG. 6, the display device 10 may include a first bank BNL1 including portions disposed at outer portions of the display area DPA and a first valley part VA1, a second bank BNL2, and a third bank BNL3 disposed in the non-display area NDA to surround the display area DPA.

The first bank BNL1 may extend in the first direction DR1 and the second direction DR2 in the display area DPA. For example, the first bank BNL1 may surround portions in which pixels PX are disposed at the outer portions of the display area DPA. Only portions of the first bank BNL1 disposed at the outermost portions of the display area DPA have been illustrated in FIG. 7, but the first bank BNL1 may extend in the first direction DR1 or the second direction DR2 to cross the display area DPA, and may also be disposed at boundaries between the respective sub-pixels SPXn. The first bank BNL1 may divide different sub-pixels SPXn by dividing the display area DPA and the non-display area NDA.

The second bank BNL2 and the third bank BNL3 spaced apart from the first bank BNL1 and surrounding the display area DPA may be disposed in the non-display area NDA. The second bank BNL2 may be spaced apart from the first bank BNL1 by an interval (e.g., as predetermined), and the third bank BNL3 may be spaced apart from the second bank BNL2 by an interval (e.g., as predetermined). For example, the display area DPA may be disposed inside an area surrounded by the second bank BNL2, and the second bank BNL2 may be disposed inside the third bank BNL3.

As described above, the display device 10 may have a structure in which layers are sequentially stacked on a first substrate SUB. Some layers of the display device 10 may be made of an organic material, and may be formed through a process in which the organic material is directly sprayed or injected onto the first substrate SUB. Since the organic material may flow with fluidity, the organic material sprayed or injected onto the display area DPA may overflow into the non-display area NDA. The second bank BNL2 and the third bank BNL3 may prevent the organic material from overflowing into the outside of the non-display area NDA beyond the non-display area NDA.

The display device 10 according to an embodiment may include the first valley part VA1 disposed between the first bank BNL1 and the second bank BNL2 in the non-display area NDA, e.g., in a plan view. The second bank BNL2 and the first bank BNL1 may have a shape protruding in an upward direction (e.g., in the third direction DR3), in case that the first valley part VA1 may be formed by partially recessing a lower layer. The first valley part VA1 forms engraved and embossed patterns together with the second bank BNL2 and the first bank BNL1 to prevent the organic material sprayed or injected onto the display area DPA from overflowing into the non-display area NDA.

The light emitting element layer EDL including the electrodes RME, the light emitting elements ED, and the connection electrodes CNE may be disposed in the display area DPA. The light emitting element layer EDL may be disposed on the via layer VIA in the display area DPA, and insulating layers PAS_S may be disposed over the display area DPA and the non-display area NDA on the via layer VIA. Although not explicitly illustrated in the drawings, the insulating layers PAS_S may include the first insulating layer PAS1 disposed below the light emitting elements ED and the second insulating layer PAS2 and the third insulating layer PAS3 disposed above the light emitting element ED. Some of the insulating layers PAS_S may be sequentially stacked on the via layer VIA in the non-display area NDA.

The fourth insulating layer PAS4 may also cover the light emitting element layer EDL, and may be disposed over the display area DPA and the non-display area NDA. The fourth insulating layer PAS4 may be disposed on the light emitting element layer EDL in the display area DPA, and may be directly disposed on other insulating layers PAS_S in the non-display area NDA.

For example, as encapsulation structures disposed on the color control members WCL1, WCL2, and TPL, the first capping layer CPL1 and the second capping layer CPL2 may also extend to the non-display area NDA. A portion of the first capping layer CPL1 may be directly disposed on the fourth insulating layer PAS4, and another portion of the first capping layer CPL1 may be directly disposed on the first bank BNL1, the second bank BNL2, and the third bank BNL3. The second capping layer CPL2 may be disposed on the first capping layer CPL1 with the low refraction layer LRL interposed therebetween. The low refraction layer LRL does not extend over the entirety of the non-display area NDA unlike the display area DPA, and thus, a portion of the second capping layer CPL2 may be directly disposed on the first capping layer CPL1.

As described above, the low refraction layer LRL may be made of an organic material, and may be disposed over the entirety of the display area DPA. In a process of applying the organic material onto the first capping layer CPL1, the organic material may overflow into the non-display area NDA beyond the first bank BNL1 disposed at the outermost portion of the display area DPA. The display device 10 may include a first substrate SUB, and layers may be formed on the first substrate SUB through continuous processes. During this process, the organic material overflowing into an undesired area of the non-display area NDA may remain as a foreign material in a subsequent process. The display device 10 according to an embodiment may prevent the organic material overflowing into the non-display area NDA from further spreading to the undesired area by including structures disposed in the non-display area NDA and having engraved and embossed pattern shapes.

The display device 10 may include the first valley part VA1, the second bank BNL2, and the third bank BNL3 disposed in the non-display area NDA. The first valley part VA1 may have an engraved pattern shape that is recessed to a lower surface of the via layer VIA on the basis of an upper surface of the via layer VIA, and the second bank BNL2 and the third bank BNL3 may have an embossed pattern shape protruding in an upward direction (e.g., in the third direction DR3) on the basis of the upper surfaces of the via layer VIA.

The first valley part VA1 may surround the display area DPA and be spaced apart from the first bank BNL1, in a plan view. The first valley part VA1 may have a first width W1 and penetrate through the first via layer VIA1, and some layers disposed on the via layer VIA may be disposed in the first valley part VA1. For example, the first insulating layer PAS1 disposed below the light emitting elements ED among the insulating layers PAS_S directly disposed on the via layer VIA may be disposed in the first valley part VA1 to be directly in contact with inner sidewalls of the first valley part VA1 in the via layer VIA. Portions of the fourth insulating layer PAS4 disposed on the insulating layers PAS_S in the non-display area NDA and the first capping layer CPL1 of which a portion is disposed directly on the fourth insulating layer PAS4 may also be disposed in the first valley part VA1. The insulating layers PAS_S, the fourth insulating layer PAS4, and the first capping layer CPL1 may include an inorganic insulating material, and may be disposed along a step formed by the first valley part VA1 in the via layer VIA. The inorganic insulating material, which is used to form the insulating layers PAS_S, the fourth insulating layer PAS4, and the first capping layer CPL1, may be disposed in the first valley part VA1, and may thus prevent external moisture from being permeated into the circuit layer CCL exposed by the first valley part VA1.

The low refraction layer LRL may be disposed on the first capping layer CPL1, and a portion of the low refraction layer LRL may be disposed in the non-display area NDA beyond the first bank BNL1. The low refraction layer LRL may also be disposed on the first valley part VA1, and a portion of the low refraction layer LRL may fill the step formed by the first valley part VA1. In a process of forming the low refraction layer LRL, the organic material constituting the low refraction layer LRL may fill the step formed by the first valley part VA1 while flowing to the non-display area NDA beyond the display area DPA, and the first valley part VA1 may prevent the organic material from excessively overflowing. The low refraction layer LRL may extend to the second bank BNL2 while filling the first valley part VA1.

The second bank BNL2 and the third bank BNL3 may be spaced apart from each other, may surround the first valley part VA1, and may be spaced apart from the first valley part VA1. The first valley part VA1, the second bank BNL2, and the third bank BNL3 may be sequentially disposed to be spaced apart from each other along a direction toward an outer portion of the non-display area NDA on the basis of the first bank BNL1. The second bank BNL2 and the third bank BNL3 may be directly disposed on the fourth insulating layer PAS4 and may have a shape protruding in the upward direction (e.g., in the third direction DR3), unlike the first valley part VA1. The second bank BNL2 and the third bank BNL3 may have the embossed pattern shape, and thus prevent the low refraction layer LRL from overflowing into the outer portion of the non-display area NDA.

According to an embodiment, widths of the second bank BNL2 and the third bank BNL3 may be the same as each other, and the first width W1 of the first valley part VA1 may be greater than a second width W2 of the second bank BNL2 and the third bank BNL3 in a cross-sectional view. The second bank BNL2 and the third bank BNL3 may be formed in the same process after the light emitting element layer EDL and the fourth insulating layer PAS4 are formed in the display area DPA. Only positions at which the second bank BNL2 and the third bank BNL3 are disposed are different from each other, shapes and materials of the second bank BNL2 and the third bank BNL3 may be the same as each other, and the widths W2 of the second bank BNL2 and the third bank BNL3 in a cross-sectional view may be the same as each other.

The first valley part VA1 may be disposed more adjacent to the display area DPA than the second bank BNL2 and the third bank BNL3 are, and may be a primary structure preventing the overflowing of the low refraction layer LRL. The first valley part VA1 may have a relatively greater width than the second bank BNL2 and the third bank BNL3 in order to prevent the overflowing of the organic material of the low refraction layer LRL. The second bank BNL2 and the third bank BNL3 may have a relatively smaller width than the first valley part VA1, but may have a width (e.g., as predetermined) and have the embossed pattern shape to prevent the organic material from overflowing into the outermost portion of the non-display area NDA beyond the first valley part VA1.

For example, the first bank BNL1 may also be formed by the same process by which the second bank BNL2 and the third bank BNL3 are formed. The first bank BNL1 may overlap the lower bank layer LBN, may be directly disposed on the fourth insulating layer PAS4, and may be disposed in a lattice pattern at an inner side of the display area DPA to surround the inner side of the display area DPA at the outermost portion of the display area DPA. However, according to an embodiment, a third width W3, which is a width of the first bank BNL1 in a cross-sectional view, may be the same as or smaller than the second width W2 of the second bank BNL2. The first bank BNL1 may form spaces in which the color control members TPL, WCL1, and WCL2 are disposed to divide neighboring sub-pixels SPXn in the display area DPA. The second bank BNL2 and the third bank BNL3 may be structures for preventing the overflowing of the low refraction layer LRL, and uses of the second bank BNL2 and the third bank BNL3 may be different from that of the first bank BNL1. For example, since the first bank BNL1, the second bank BNL2, and the third bank BNL3 are directly disposed on the fourth insulating layer PAS4, they are formed by the same process, but their widths may vary according to their functions. The second bank BNL2 and the third bank BNL3 disposed in the non-display area NDA as the structures for preventing the overflowing of the organic material may have a width that is the same as or greater than that of the first bank BNL1.

The overcoat layer OC may cover the color filter layers CFL and the light blocking member BM in the display area DPA, and a portion of the overcoat layer OC may also be disposed in the non-display area NDA. Similar to the low refraction layer LRL, the overcoat layer OC may be made of an organic material, and an overflow problem may occur on the color filter layers CFL and the second capping layer CPL2. The display device 10 according to an embodiment may further include color dams CBN1 and CBN2 disposed on the second bank BNL2 and the third bank BNL3 as structures for preventing overflow of the overcoat layer OC.

Color dams CBN1 and CBN2 may be disposed on the second bank BNL2 and the third bank BNL3, respectively. The color dams CBN1 and CBN2 may be disposed on any one of the second bank BNL2 and the third bank BNL3, respectively, at the left outer portion and the right outer portion, which are both sides in the second direction DR2, of the outer portions of the display device 10. For example, the color dams CBN1 and CBN2 may include first color dams CBN1 disposed on the second bank BNL2 and the third bank BNL3 of the left outer portion (see FIG. 8) of the display device 10 and second color dams CBN2 disposed on the second bank BNL2 and the third bank BNL3 of the right outer portion (see FIG. 9) of the display device 10. The color dams CBN1 and CBN2 adjacent to each other in the outer portion of a side of the display device 10 may be spaced apart from each other in the second direction DR2, and the respective color dams CBN1 and CBN2 may extend in the first direction DR1 on the second bank BNL2 or the third bank BNL3. The color dams CBN1 and CBN2 may form linear patterns in the non-display area NDA.

Similar to the second bank BNL2 and the third bank BNL3 preventing the low refraction layer LRL disposed below the second capping layer CPL2 from overflowing in the non-display area NDA, the color dams CBN1 and CBN2 may prevent the overcoat layer OC disposed above the second capping layer CPL2 from overflowing in the non-display area NDA. Each of the color dams CBN1 and CBN2 may be directly disposed on the second capping layer CPL2, have a thickness (e.g., as predetermined) and a width (e.g., as predetermined), and have an embossed pattern having a protruding shape.

In an embodiment, a width of each of the first color dam CBN1 and the second color dam CBN2 in the second direction DR2 may be smaller than the second width W2 of the second bank BNL2, and a thickness of each of the first color dam CBN1 and the second color dam CBN2 may also be smaller than that of the second bank BNL2. The color dams CBN1 and CBN2 may have sizes enough to prevent the organic material of the layer made of the organic material among the layers disposed on the second capping layer CPL2 from overflowing. The second bank BNL2 and the third bank BNL3 disposed below the second capping layer CPL2 may be structures for preventing the overflowing of the low refraction layer LRL and the overcoat layer OC, in case that the color dams CBN1 and CBN2 may be structures for preventing the overflowing of the overcoat layer OC and may have a relatively small size.

According to an embodiment, the color dams CBN1 and CBN2 may include the same material as some of the color filter layers CFL1, CFL2, and CFL3 and may be formed by the same process by which some of the color filter layers CFL1, CFL2, and CFL3 is formed. Since the color dams CBN1 and CBN2 and the color filter layers CFL1, CFL2, and CFL3 are directly disposed on the second capping layer CPL2, respectively, in case that the color dams CBN1 and CBN2 and the color filter layers CFL1, CFL2, and CFL3 include the same material, the color dams CBN1 and CBN2 and the color filter layers CFL1, CFL2, and CFL3 may be formed by the same process. However, the color dams CBN1 and CBN2 and the color filter layers CFL1, CFL2, and CFL3 may be disposed in different areas, may perform different roles, and may have different arrangements in a plan view. For example, the color filter layers CFL1, CFL2, and CFL3 may be disposed in the light transmitting areas TA1, TA2, and TA3 of the display device 10 and be formed as linear or island patterns, and the color dams CBN1 and CBN2 may be disposed in the non-display area NDA and be formed in linear patterns.

According to an embodiment, the first color dam CBN1 disposed at the left outer portion of the display device 10 may include a different material from the second color dam CBN2 disposed at the right outer portion of the display device 10. The first color dam CBN1 and the first color filter layer CFL1 may include a same material. The second color dam CBN2 and the third color filter layer CFL3 may include a same material. In the display device 10, a pixel PX may include the first sub-pixel SPX1, the second sub-pixel SPX2, and the third sub-pixel SPX3, which may be sequentially disposed in the second direction DR2. The pixels PX may be arranged in the first direction DR1 and the second direction DR2 in the display area DPA of the display device 10, and the first sub-pixels SPX1, the second sub-pixels SPX2, and the third sub-pixels SPX3 may also be repeatedly arranged in the first direction DR1 and the second direction DR2. The numbers of first sub-pixels SPX1, second sub-pixels SPX2, and third sub-pixels SPX3 disposed in the display area DPA may be the same as each other, and in case that the first sub-pixels SPX1, the second sub-pixels SPX2, and the third sub-pixels SPX3 are repeatedly arranged in the second direction DR2, a sub-pixel SPXn disposed most adjacent to a left non-display area NDA in the display area DPA may be the first sub-pixel SPX1, and a sub-pixel SPXn disposed most adjacent to a right non-display area NDA in the display area DPA may be the third sub-pixel SPX3. For example, the first color filter layer CFL1 may be disposed on the sub-pixel SPXn disposed most adjacent to the left non-display area NDA in the display area DPA, and the third color filter layer CFL3 may be disposed on the sub-pixel SPXn disposed most adjacent to the right non-display area NDA in the display area DPA.

As described above, the color dams CBN1 and CBN2 may include the same material as any one of the color filter layers CFL1, CFL2, and CFL3 and may be formed by the same process by which any one of the color filter layers CFL1, CFL2, and CFL3 is formed. The first color dam CBN1 disposed at the left outer portion may include the same material as a color filter layer disposed most adjacent to the first color dam CBN1, for example, the first color filter layer CFL1, and the second color dam CBN2 disposed at the left outer portion may include the same material as a color filter layer disposed most adjacent to the second color dam CBN2, for example, the third color filter layer CFL3.

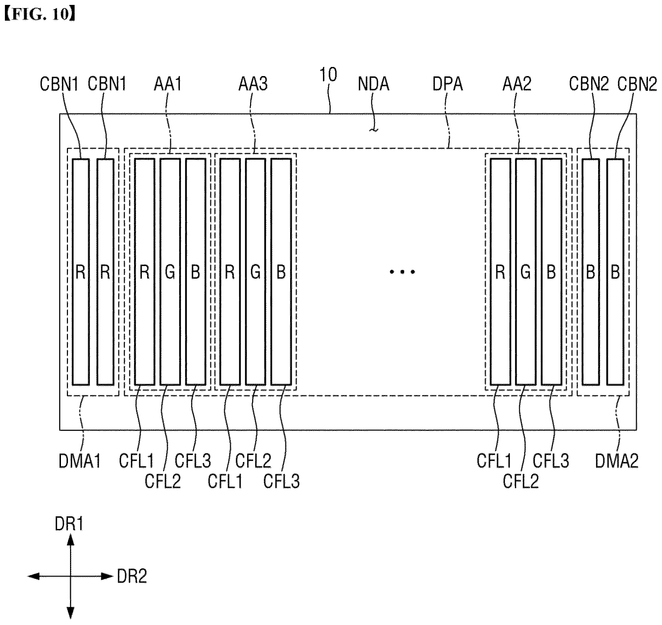

FIG. 10 is a schematic view illustrating an arrangement of color filter layers and color dams of the display device according to an embodiment.

Referring to FIG. 10 in conjunction with FIGS. 7 to 9, in the display device 10, the display area DPA may include areas AA1, AA2, and AA3, and the non-display area NDA may include dam areas DMA1 and DMA2. For example, the display device 10 may include a first dam area DMA1 disposed on the left side, which is a side of the non-display area NDA in the second direction DR2, and a second dam area DMA2 disposed on the right side, which is the other side of the non-display area NDA in the second direction DR2. The display area DPA may include a first area AA1 and a second area AA2 disposed at the outermost portions of the display area DPA in the second direction DR2 and third areas AA3 that are inner areas between the first area AA1 and the second area AA2, as areas AA1, AA2, and AA3 divided according to areas in which the same color filter layers CFL1, CFL2, and CFL3 are repeatedly disposed. Color filter layers CFL1, CFL2, and CFL3 may be disposed in each of the first area AA1, the second area AA2, and the third areas AA3, and different color dams CBN1 and CBN2 may be disposed in the first dam area DMA1 and the second dam area DMA2, respectively.

The first color filter layer CFL1, the second color filter layer CFL2, and the third color filter layer CFL3 may be sequentially disposed in the second direction DR2 in each of the first area AA1, the second area AA2, and the third areas AA3. Different areas AA1, AA2, and AA3 may be areas divided according to areas in which the repeatedly arranged color filter layers CFL1, CFL2, and CFL3 are disposed. The respective areas AA1, AA2, and AA3 may be areas in which a set of first color filter layer CFL1, second color filter layer CFL2, and third color filter layer CFL3 are disposed, and the first area AA1 and the second area AA2 of the respective areas AA1, AA2, and AA3 may be areas disposed at the outermost portions of the display area DPA in the second direction DR2 and the third areas AA3 of the respective areas AA1, AA2, and AA3 may be areas disposed on the inner side.

The first dam area DMA1 may be disposed in the left non-display area NDA and be adjacent to the first area AA1 of the display area DPA. A color filter layer disposed on the left side of the first area AA1 may be the first color filter layer CFL1, and each of the first color dams CBN1 disposed in the first dam area DMA1 may include the same material as the first color filter layer CFL1. The second dam area DMA2 may be disposed in the right non-display area NDA and be adjacent to the second area AA2 of the display area DPA. A color filter layer disposed on the right side of the second area AA2 may be the third color filter layer CFL3, and each of the second color dams CBN2 disposed in the second dam area DMA2 may include the same material as the third color filter layer CFL3. In the processes of manufacturing the display device 10, the first color dams CBN1 disposed in the first dam area DMA1 may be formed by the same process by which the first color filter layer CFL1 disposed in the first area AA1 is formed. The second color dams CBN2 disposed in the second dam area DMA2 may be formed by the same process by which the third color filter layer CFL3 disposed in the second area AA2 is formed.

In an embodiment, each of the color filter layers CFL1, CFL2, and CFL3 and the color dams CBN1 and CBN2 may be formed by a patterning process by using a mask. The color filter layers CFL1, CFL2, and CFL3 and the color dams CBN1 and CBN2 include different materials, and may thus be formed by different mask processes. For example, in the display device 10, the first color filter layers CFL1 may be first formed, the second color filter layers CFL2 may be formed by another process, and the third color filter layers CFL3 may be formed by still another process.

For example, the respective color filter layers CFL1, CFL2, and CFL3 may be separately formed through a plurality of processes rather than a single process in the entirety of the display device 10. Some portion of the first color filter layers CFL1 disposed in the areas AA1, AA2, and AA3 of the display area DPA may be formed by different processes. The first color filter layers CFL1 disposed in the first area AA1 and some portion of the third areas AA3 may be formed by a process different from that of each of the first color filter layers CFL1 disposed in the others of the third areas AA3 and the first color filter layers CFL1 disposed in another third area AA3 and the second area AA2. Similarly, the second color filter layers CFL2 and the third color filter layers CFL3 disposed in the areas AA1, AA2, and AA3 may be formed by different mask processes, respectively.

According to an embodiment, the color dams CBN1 and CBN2 may be formed together with color filter layers CFL1, CFL2, and CFL3 disposed in areas disposed in the outermost portions of the display area DPA in a mask process for forming the color filter layers CFL1, CFL2, and CFL3 disposed in the areas disposed in the outermost portions of the display area DPA among mask processes for forming the color filter layers CFL1, CFL2, and CFL3. For example, the first color dam CBN1 may be formed together with the first color filter layer CFL1 in a mask process for forming the first color filter layer CFL1 disposed in the first area AA1, and the second color dam CBN2 may be formed together with the third color filter layer CFL3 in a mask process for forming the third color filter layer CFL3 disposed in the second area AA2.

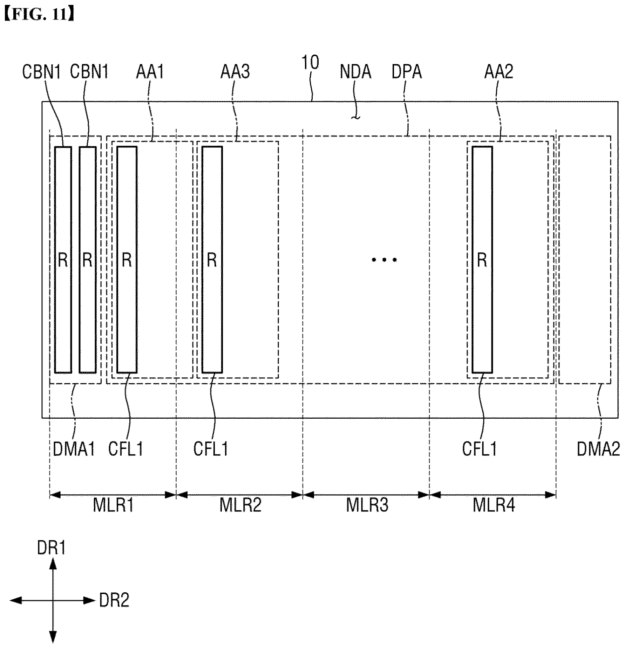

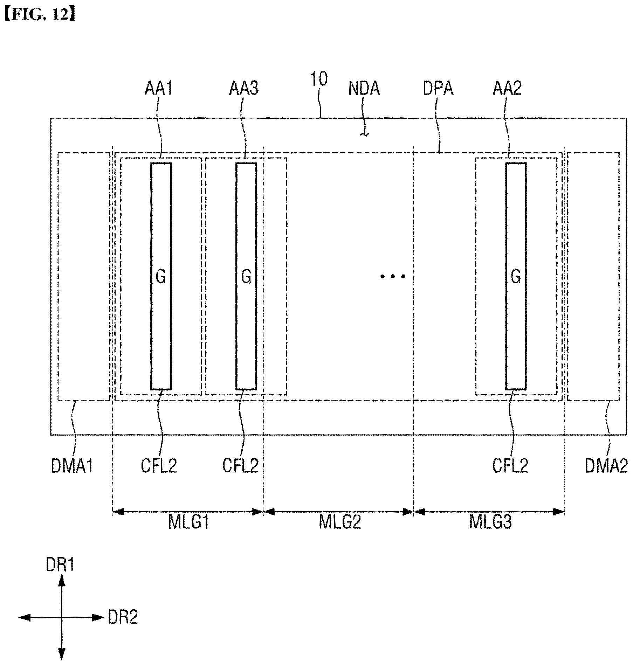

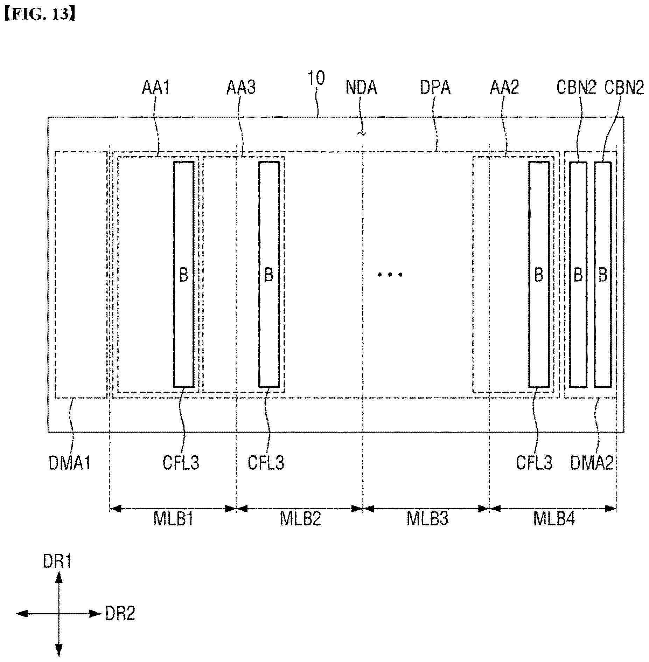

FIG. 11 is a schematic view illustrating mask processes for forming first color filter layers and first color dams of the display device according to an embodiment. FIG. 12 is a schematic view illustrating mask processes for forming second color filter layers of the display device according to an embodiment. FIG. 13 is a schematic view illustrating mask processes for forming third color filter layers and second color dams of the display device according to an embodiment.

Referring to FIGS. 11 to 13, in the display device 10, mask processes may be performed in order to form different color filter layers CFL1, CFL2, and CFL3. The color dams CBN1 and CBN2 of the dam areas DMA1 and DMA2 may be formed together with the color filter layers CFL1, CFL2, and CFL3 in some portion of processes of forming the respective color filter layers CFL1, CFL2, and CFL3.

Mask processes for forming the first color filter layers CFL1 may be performed over the first dam area DMA1 and the display area DPA. In the mask processes, a first mask process may be performed in a first mask area MLR1 including the first dam area DMA1 and a portion of the first area AA1. In the first mask process, the first color dams CBN1 of the first dam area DMA1 and the first color filter layer CFL1 of the first area AA1 may be simultaneously formed. Second to fourth mask processes after the first mask process may be performed respectively in a second mask area MLR2, a third mask area MLR3, and a fourth mask area MLR4 including areas in which the first color filter layers CFL1 of the areas AA2 and AA3 other than the first area AA1 in the display area DPA are disposed.

Similarly, mask processes for forming the third color filter layers CFL3 may be performed over the second dam area DMA2 and the display area DPA. In the mask processes, a fourth mask process may be performed in a fourth mask area MLB4 including the second dam area DMA2 and a portion of the second area AA2. In the fourth mask process, the second color dams CBN2 of the second dam area DMA2 and the third color filter layer CFL3 of the second area AA2 may be simultaneously formed. First to third mask processes before the fourth mask process may be performed respectively in a first mask area MLB1, a second mask area MLB2, and a third mask area MLB3 including areas in which the third color filter layers CFL3 of the areas AA1 and AA3 other than the second area AA2 in the display area DPA are disposed.

For example, mask processes for forming the second color filter layers CFL2 may be performed only in the display area DPA. In the mask processes, first to third mask processes may be performed respectively in a first mask area MLG1, a second mask area MLG2, and a third mask area MLG3 including areas in which the second color filter layers CFL2 of the first to third areas AA1 to AA3 are disposed.

In an embodiment, mask areas in which the respective mask processes are performed may have the same size. For example, the first to fourth mask areas MLR1, MLR2, MLR3, and MLR4 in which the mask processes for forming the first color filter layers CFL1 are performed may have the same width. The first to fourth mask areas MLR1, MLR2, MLR3, and MLR4 may have a width obtained by dividing the first dam area DMA1 and the display area DPA at substantially equal intervals. Similarly, the first to fourth mask areas MLB1, MLB2, MLB3, and MLB4 in which the mask processes for forming the third color filter layers CFL3 are performed may have the same width. The first to fourth mask areas MLB1, MLB2, MLB3, and MLB4 may have a width obtained by dividing the second dam area DMA2 and the display area DPA at substantially equal intervals. For example, the first to third mask areas MLG1, MLG2, and MLG3 in which the mask processes for forming the second color filter layers CFL2 are performed may have a width obtained by dividing the display area DPA at substantially equal intervals.

As described above, the color filter layers CFL1, CFL2, and CFL3 may be repeatedly arranged in the respective areas AA1, AA2, and AA3 of the display area DPA, and the mask processes for forming the color filter layers CFL1, CFL2, and CFL3 may be performed respectively in the mask areas having the same width by using mask layers having the same width. In order to form the color dams CBN1 and CBN2 including the same material as the color filter layers CFL1, CFL2, and CFL3 in the dam areas DMA1 and DMA2 in addition to forming the color filter layers CFL1, CFL2, and CFL3 in the display area DPA, it may be necessary to design the mask areas in which the respective mask processes are performed and the mask layers.

In the display device 10, the color dams CBN1 and CBN2 disposed in the first dam area DMA1 and the second dam area DMA2 may be formed by the processes for forming the different color filter layers CFL1, CFL2, and CFL3, respectively. In order to form different color dams CBN1 and CBN2, the mask processes for forming the first color filter layers CFL1 and the third color filter layers CFL3 may be performed once more than the mask processes for forming the second color filter layers CFL2. In the display device 10 according to an embodiment, the color filter layers CFL1, CFL2, and CFL3 and the color dams CBN1 and CBN2 may be formed by adding as few mask processes as possible, such that the number of manufacturing processes may be reduced.

Hereinafter, other embodiments of the display device 10 will be described with reference to other drawings.

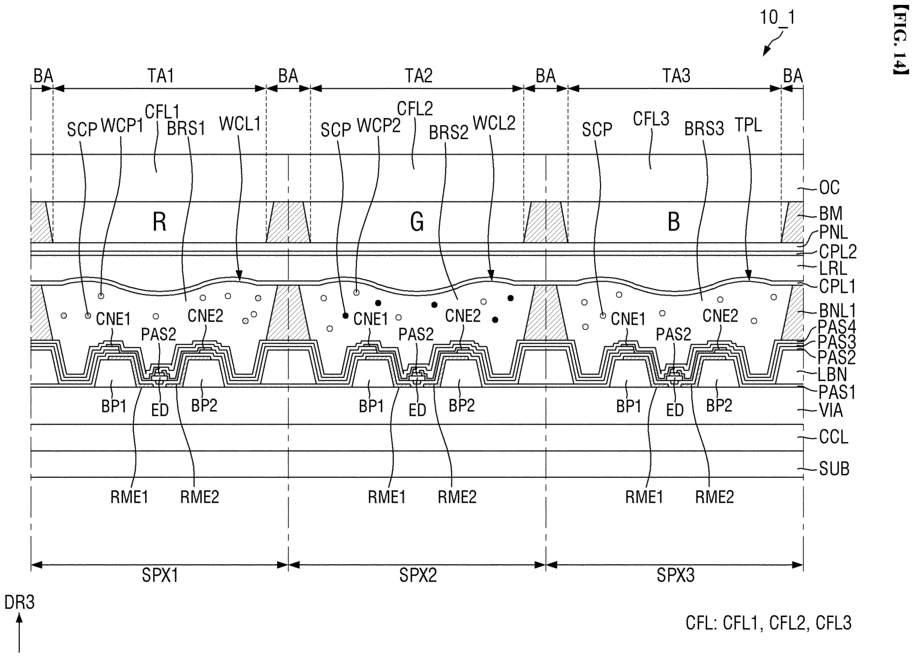

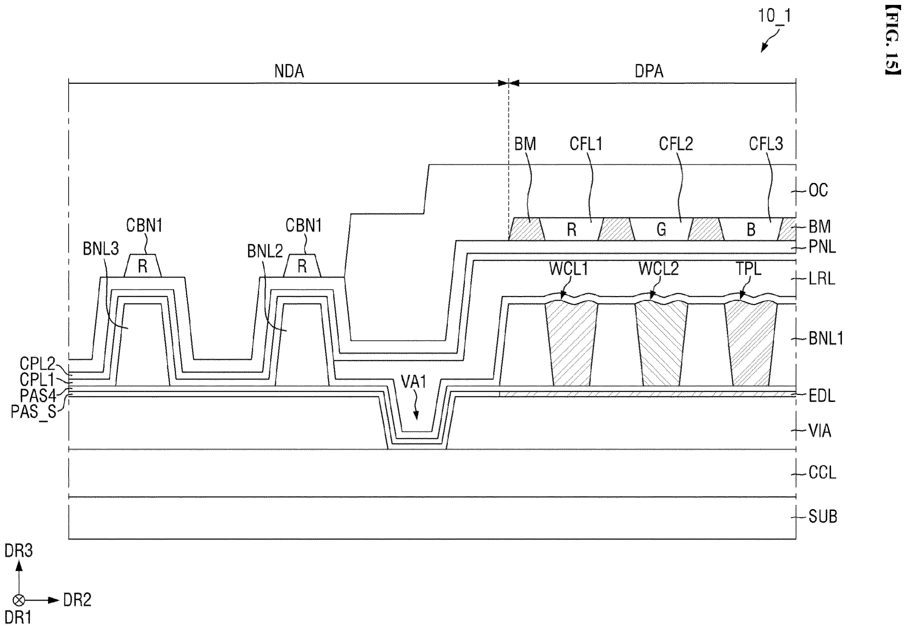

FIG. 14 is a schematic cross-sectional view of a display device according to an embodiment. FIG. 15 is a schematic cross-sectional view illustrating an outer portion of the display device of FIG. 14.

Referring to FIGS. 14 and 15, a display device 10_1 according to an embodiment may further include a planarization layer PNL disposed on the second capping layer CPL2. The display device 10_1 according to an embodiment is different from the display device according to an embodiment of FIGS. 6 and 8 in that it further includes the planarization layer PNL. Hereinafter, a description of redundant contents will be omitted, and contents different from those described above will be described for descriptive convenience.

The planarization layer PNL may be disposed over the entirety of the display area DPA and the non-display area NDA on the second capping layer CPL2. The planarization layer PNL may overlap the color control members TPL, WCL1 and WCL2 in the display area DPA, and may also be disposed on the second bank BNL2 and the third bank BNL3 in the non-display area NDA. The light blocking members BM, the color filter layers CFL1, CFL2, and CFL3, and the color dams CBN1 and CBN2 may be directly disposed on the planarization layer PNL, respectively.

The planarization layer PNL may protect members disposed on the first substrate SUB in addition to the capping layers CPL1 and CPL2 and the low refraction layer LRL, and partially compensate for a step (e.g., an unevenness) caused by these members. For example, the planarization layer PNL may compensate for a step (e.g., an unevenness) formed by the color control members TPL, WCL1, and WCL2 and the first bank BNL1 disposed below the planarization layer PNL in the display area DPA, and the light blocking members BM and the color filter layers CFL1, CFL2, and CFL3 disposed on the planarization layer PNL may be formed on a substantially flat surface.

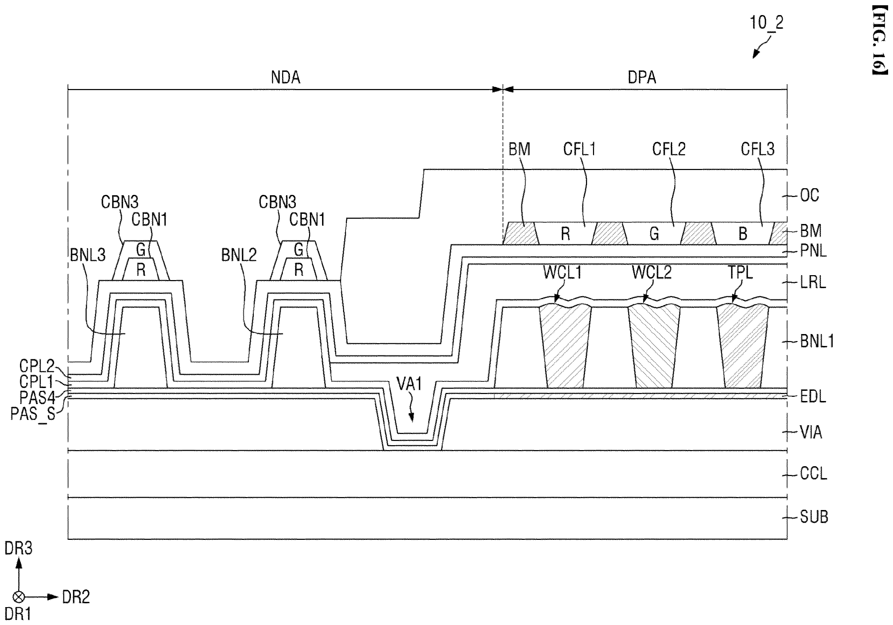

FIG. 16 is a schematic cross-sectional view illustrating an outer portion of a display device according to an embodiment.

Referring to FIG. 16, a display device 10_2 according to an embodiment may further include third color dams CBN3 each disposed on the first color dams CBN1. The display device 10_2 is different from the display device 10_1 of FIG. 15 in that it further includes the third color dams CBN3 covering the first color dams CBN1. Hereinafter, a description of redundant contents will be omitted, and contents different from those described above will be described for descriptive convenience.

The third color dams CBN3 may be disposed on the first color dams CBN1. The third color dams CBN3 may be disposed at the left outer portion of the display device 10 or on the second bank BNL2 and the third bank BNL3 in the first dam area DMA1. For example, the third color dams CBN3 may extend in the first direction DR1 in the first dam area DMA1, and adjacent third color dams CBN3 may be spaced apart from each other in the second direction DR2.

The third color dam CBN3 may be formed to have a greater width than the first color dam CBN1 to completely cover an outer surface of the first color dam CBN1. However, embodiments are not limited thereto. The third color dam CBN3 may have a width that is the same as or smaller than that of the first color dam CBN1, and the third color dam CBN3 may be disposed only on an upper surface of the first color dam CBN1. For example, side surfaces of the first color dam CBN1 may be exposed.

According to an embodiment, the third color dam CBN3 and the second color filter layer CFL2 may include a same material. Similar to the first color dam CBN1, the third color dam CBN3 may be formed together with the second color filter layer CFL2 in a process of forming the second color filter layer CFL2 disposed in the first area AA1.

The second color dam CBN2 and the third color filter layer CFL3 may include a blue colorant. The second color dam CBN2 including the blue colorant may absorb some portion of reflected light by light incident from the outside to reduce the reflected light by external light. Similarly, the first color dam CBN1 and the third color dam CBN3 may include a red colorant and a green colorant, respectively. The first color filter layer CFL1 and the second color filter layer CFL2 may include a red colorant and a green colorant, respectively. The first color dam CBN1 and the third color dam CBN3 may be stacked each other in the thickness direction, and may absorb some portion of reflected light by light incident from the outside to reduce the reflected light by external light, similar to the second color dam CBN2 including the blue colorant.

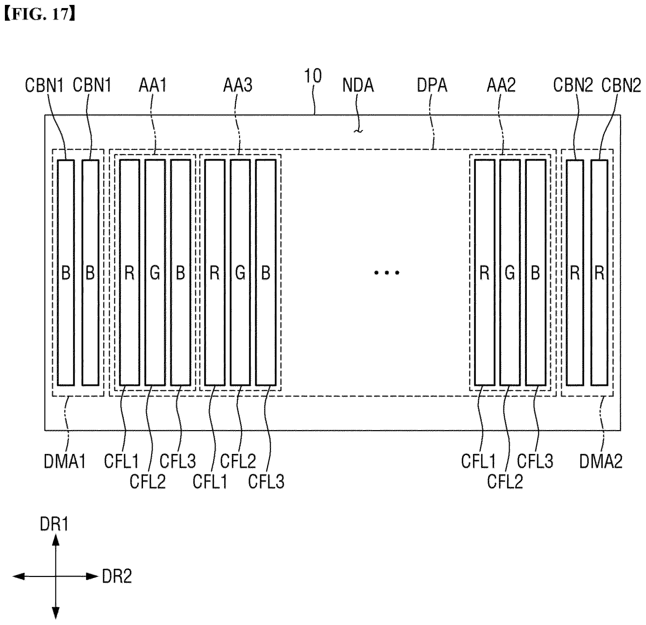

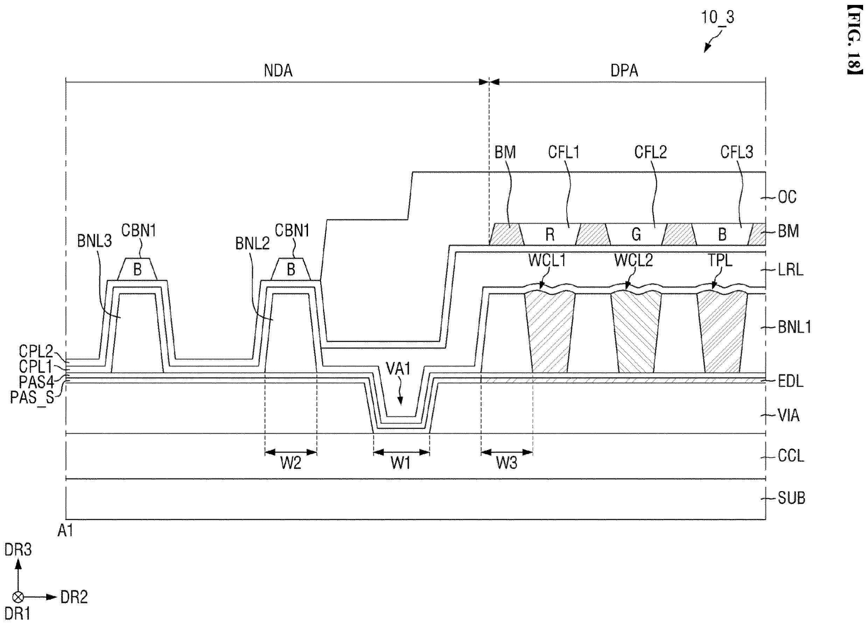

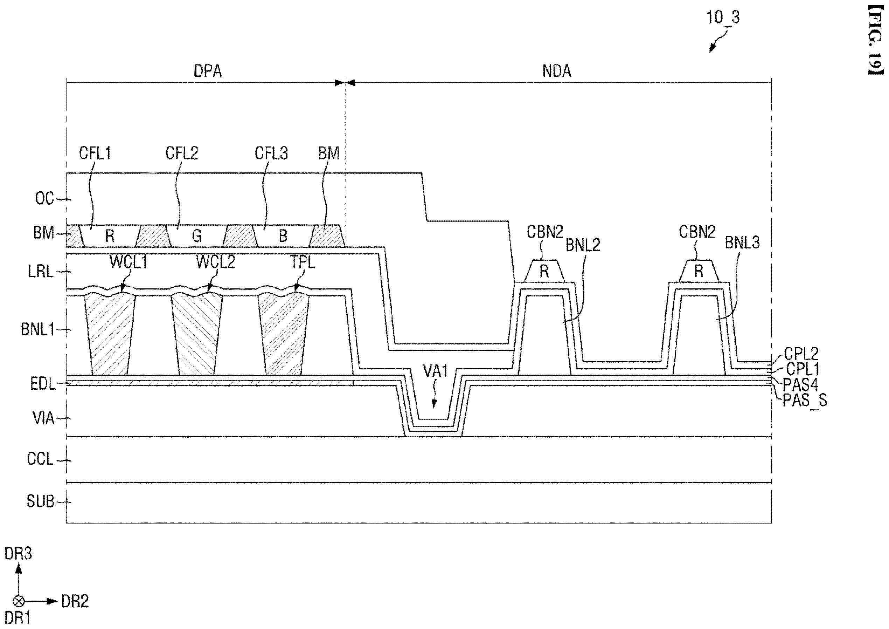

FIG. 17 is a schematic view illustrating an arrangement of color filter layers and color dams of the display device according to an embodiment. FIGS. 18 and 19 are schematic cross-sectional views illustrating an outer portion of the display device of FIG. 17.

Referring to FIGS. 17 to 19, in a display device 10_3 according to an embodiment, the first color dam CBN1 and the third color filter layer CFL3 may include a same material. The second color dam CBN2 and the first color filter layer CFL1 may include a same material. The embodiment of FIGS. 17 to 19 is different from an embodiment of FIGS. 8 to 13 in that the first color dam CBN1 and the second color dam CBN2 include opposite materials. Hereinafter, a description of redundant contents will be omitted and contents different from those described above will be described for descriptive convenience.

In an embodiment of FIGS. 8 to 13, the first color dam CBN1 may include the same material as the first color filter layer CFL1 disposed most adjacent to the first color dam CBN1 among the color filter layers CFL1, CFL2, and CFL3 of the first area AA1. For example, the second color dam CBN2 may include the same material as the third color filter layer CFL3 disposed most adjacent to the second color dam CBN2 among the color filter layers CFL1, CFL2, and CFL3 of the second area AA2. However, embodiments are not limited thereto, and the first color dam CBN1 and the second color dam CBN2 may include the same materials as any color filter layers CFL1, CFL2, and CFL3 as long as they include different materials.

For example, the first color dam CBN1 may include the same material as the third color filter layer CFL3 most spaced apart from the first color dam CBN1 among the color filter layers CFL1, CFL2, and CFL3 of the first area AA1, and the second color dam CBN2 may include the same material as the first color filter layer CFL1 most spaced apart from the second color dam CBN2 among the color filter layers CFL1, CFL2, and CFL3 of the second area AA2. Also in the display device 10_3 according to an embodiment, in mask processes for forming the respective color filter layers CFL1, CFL2, and CFL3, the respective mask areas in which the processes are repeatedly performed may have the same width, and the color dams CBN1 and CBN2 capable of preventing the overflowing of the organic material may be formed by adding as few processes as possible. A detailed description thereof is the same as described above.

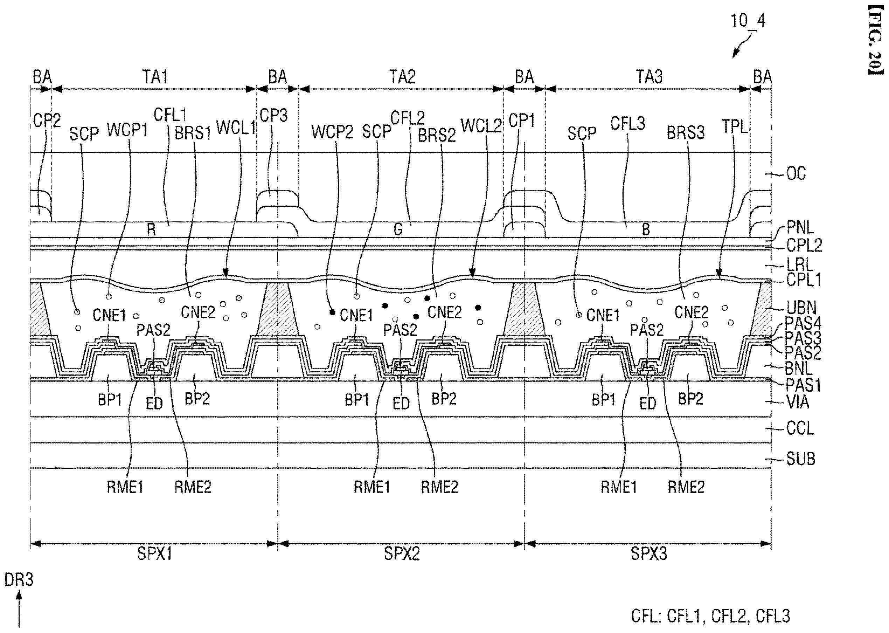

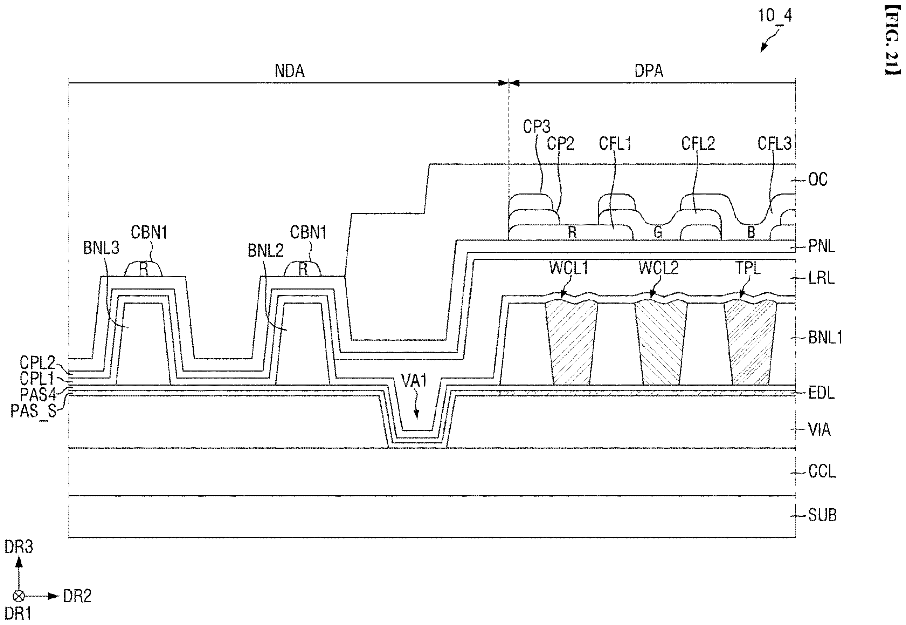

FIG. 20 is a schematic cross-sectional view of a display device according to an embodiment. FIG. 21 is a schematic cross-sectional view illustrating an outer portion of the display device of FIG. 20.

Referring to FIGS. 20 and 21, in a display device 10_4 according to an embodiment, the light blocking member BM may be omitted and color patterns CP1, CP2, and CP3 may be disposed. The embodiment of FIGS. 20 and 21 is different from the embodiment of FIG. 14 in that the light blocking member BM is replaced with the color patterns CP1, CP2, and CP3.

The color patterns CP1, CP2, and CP3 may be formed in substantially the same lattice-shaped pattern as the light blocking member BM of FIG. 14. However, the color patterns CP1, CP2, and CP3 may include the same material as the color filter layers CFL1, CFL2, and CFL3. For example, the color patterns CP1, CP2, and CP3 and the color filter layers CFL1, CFL2, and CFL3 may be integral with each other. Different color patterns CP1, CP2, and CP3 may be stacked each other and disposed in the light blocking areas BA, and transmission of the light may be blocked in the areas in which the different color patterns CP1, CP2, and CP3 are stacked each other.

A first color pattern CP1 may include the same material as the first color filter layer CFL1 and may be disposed in the light blocking area BA. The first color pattern CP1 may be directly disposed on the second capping layer CPL2 in the light blocking area BA. For example, the first color pattern CP1 and the first color filter layer CFL1 may be integral with each other in the light blocking area BA adjacent to the first light transmitting area TA1 of the first sub-pixel SPX1.

A second color pattern CP2 may include the same material as the second color filter layer CFL2 and may be disposed in the light blocking area BA. The second color pattern CP2 may be directly disposed on the first color pattern CP1 in the light blocking area BA. For example, the second color pattern CP2 and the second color filter layer CFL2 may be integral with each other in the light blocking area BA adjacent to the second light transmitting area TA2 of the second sub-pixel SPX2. Similarly, a third color pattern CP3 may include the same material as the third color filter layer CFL3 and may be disposed in the light blocking area BA. The third color pattern CP3 may be directly disposed on the second color pattern CP2 in the light blocking area BA. For example, the third color pattern CP3 and the third color filter layer CFL3 may be integral with each other in the light blocking area BA adjacent to the third light transmitting area TA3 of the third sub-pixel SPX3.

In the display device 10_4, in an area overlapping the first bank BNL1, each of the first color pattern CP1, the second color pattern CP2, and the third color pattern CP3 may overlap at least one of the color filter layers CFL1, CFL2, and CFL3 including different colorants, e.g., in a plan view. For example, the first color pattern CP1 may overlap the second color filter layer CFL2 and the third color filter layer CFL3, the second color pattern CP2 may overlap the first color filter layer CFL1 and the third color filter layer CFL3, and the third color pattern CP3 may overlap the first color filter layer CFL1 and the second color filter layer CFL2. In the area overlapping the first bank BNL1, the color patterns CP1, CP2, and CP3 and the color filter layers CFL1, CFL2, and CFL3 including the different colorants may overlap each other to function as the light blocking member BM.

Each of the first color dams CBN1 may be formed by the same process by which the first color pattern CP1 is formed, and may have the same shape as the first color pattern CP1. The first color dams CBN1 may have substantially the same shape as the first color pattern CP1 disposed between the second color filter layer CFL2 and the third color filter layer CFL3. Each of the second color dams CBN2 may be formed by the same process by which the third color pattern CP3 is formed, and may have the same shape as the third color pattern CP3. The second color dams CBN2 may have substantially the same shape as the third color pattern CP3 disposed on the second color pattern CP2.

The display device 10_4 according to an embodiment has a structure in which the color patterns CP1, CP2, and CP3 are stacked each other, and the color patterns CP1, CP2, and CP3 play the same role as the light blocking member BM, and thus, color mixing between neighboring areas due to materials having different colorants may be prevented. For example, the color patterns CP1, CP2, and CP3 include the same material as the color filter layers CFL1, CFL2, and CFL3, and thus, external light or reflected light transmitted through the light blocking areas BA may have a wavelength band of a specific color. An eye color sensibility perceived by user's eyes is different according to a color of light. For example, light of a blue wavelength band may be perceived less sensitively by a user than light of a green wavelength band and light of a red wavelength band. Since the light blocking member BM is omitted in the light blocking areas BA and the color patterns CP1, CP2, and CP3 are disposed in the light blocking areas BA, transmission of the light may be blocked or prevented, and the user may perceive the reflected light relatively less sensitively, and the reflected light by the external light may be reduced by absorbing some portion of light introduced from the outside of the display device 10_4.

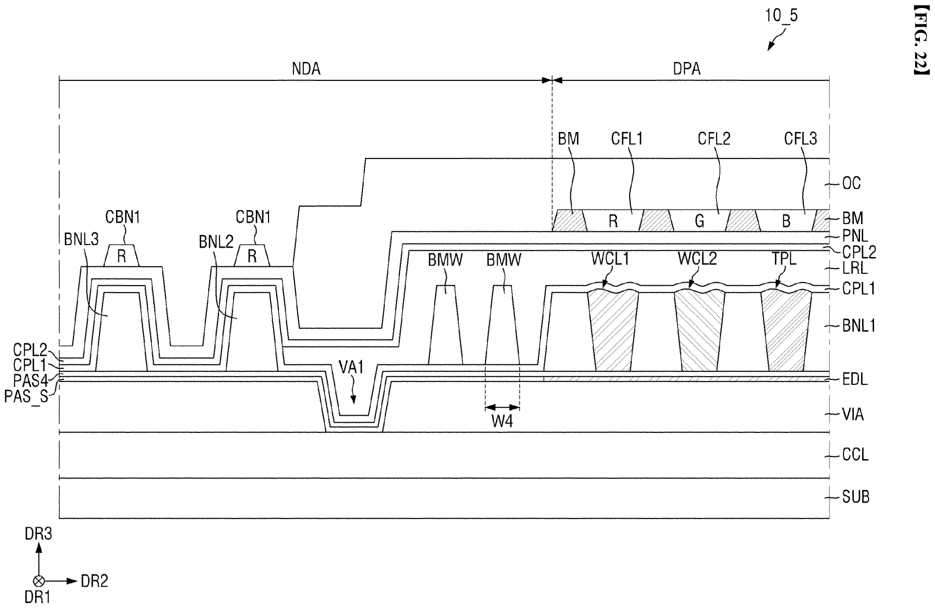

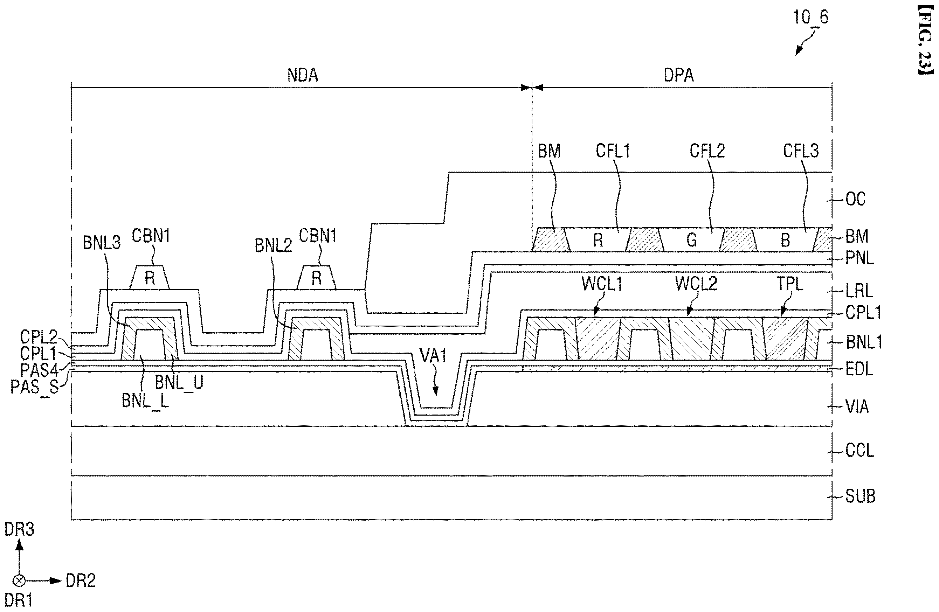

FIGS. 22 and 23 are schematic cross-sectional views illustrating outer portions of display devices according to embodiments.

Referring to FIG. 22, a display device 10_5 according to an embodiment may further include bank partition walls BMW disposed between the first bank BNL1 and the first valley part VA1. The bank partition walls BMW may be structures forming an embossed pattern, and may prevent the organic material of the low refraction layer LRL from overflowing together with the first bank BNL1, the first valley part VA1, the second bank BNL2, and the third bank BNL3. The display device 10_5 of FIG. 22 is different from the display device 10_1 of FIGS. 14 and 15 in that it further includes the bank partition walls BMW disposed in the non-display area NDA. Hereinafter, a redundant description will be omitted, and contents different from those described above will be described for descriptive convenience.

The bank partition walls BMW may be disposed between the first bank BNL1 and the first valley part VA1. The first valley part VA1 may be disposed more adjacent to the second bank BNL2 than the first bank BNL1, and the bank partition walls BMW may be disposed between the first bank BNL1 and the first valley part VA1 to more effectively prevent the overflowing of the organic material.

For example, the bank partition walls BMW may be spaced apart from the first bank BNL1 and surround the first bank BNL1, similar to the second bank BNL2. Different bank partition walls BMW may be spaced apart from each other, and the bank partition wall BMW disposed on an outer side may surround the bank partition wall BMW disposed on an inner side.

The bank partition walls BMW may be formed by the same process by which the second bank BNL2 is formed. The bank partition walls BMW may be directly disposed on the fourth insulating layer PAS4, and the first capping layer CPL1 may be directly disposed on the bank partition walls BMW. The bank partition walls BMW may be disposed in the non-display area NDA between the first bank BNL1 and the first valley part VA1, and may partially overlap the light blocking member BM. The bank partition walls BMW may have an embossed pattern shape protruding in the upward direction on the via layer VIA, and may prevent the organic materials of the low refraction layer LRL from overflowing together with the first valley part VA1.

The bank partition walls BMW may have a smaller width than other banks BNL1, BNL2, and BNL3. The bank partition walls BMW may be disposed in a relatively narrow area between the first valley part VA1 and the first bank BNL1. The bank partition walls BMW are formed by the same process by which the second bank BNL2 is formed, but may have a size adjusted according to a space of the display device 10_5.

Referring to FIG. 23, in a display device 10_6 according to an embodiment, each of the first bank BNL1, the second bank BNL2, and the third bank BNL3 may include layers BNL_L and BNL_U. Each of the first bank BNL1, the second bank BNL2, and the third bank BNL3 may include a base layer BNL_L and an upper layer BNL_U disposed on the base layer BNL_L. Compared to the embodiment of FIGS. 8 and 9, the color control members TPL, WCL1, and WCL2 of FIG. 23 may be formed by a photoresist process, and the banks BNL1, BNL2 and BNL3 may have relatively low heights.

The base layer BNL_L of each of the first bank BNL1, the second bank BNL2, and the third bank BNL3 may be directly disposed on the fourth insulating layer PAS4, and the upper layer BNL_U of each of the first bank BNL1, the second bank BNL2, and the third bank BNL3 may be may be directly disposed on the base layer BNL_L. The upper layer BNL_U may be formed to have a greater width than the base layer BNL_L to completely cover outer surfaces of the base layer BNL_L. However, embodiments are not limited thereto. The upper layer BNL_U may have a width that is the same as or smaller than that of the base layer BNL_L, and the upper layer BNL_U may be disposed only on an upper surface of the base layer BNL_L. In this case, side surfaces of the base layer BNL_L may be exposed.

In the display device 10_6, the color control members TPL, WCL1, and WCL2 may be formed by the photoresist process, and each of the first bank BNL1, the second bank BNL2, and the third bank BNL3 may have a structure in which the base layer BNL_L and the upper layer BNL_U are stacked each other. Compared to the embodiment of FIGS. 8 and 9, the first bank BNL1, the second bank BNL2, and the third bank BNL3 of FIG. 23 may have relatively low heights, and upper surfaces of respective layers of the color control members TPL, WCL1, and WCL2 may be formed to be flat. The upper surfaces of the color control members TPL, WCL1, and WCL2 may be formed in substantially parallel with an upper surface of the first bank BNL1.

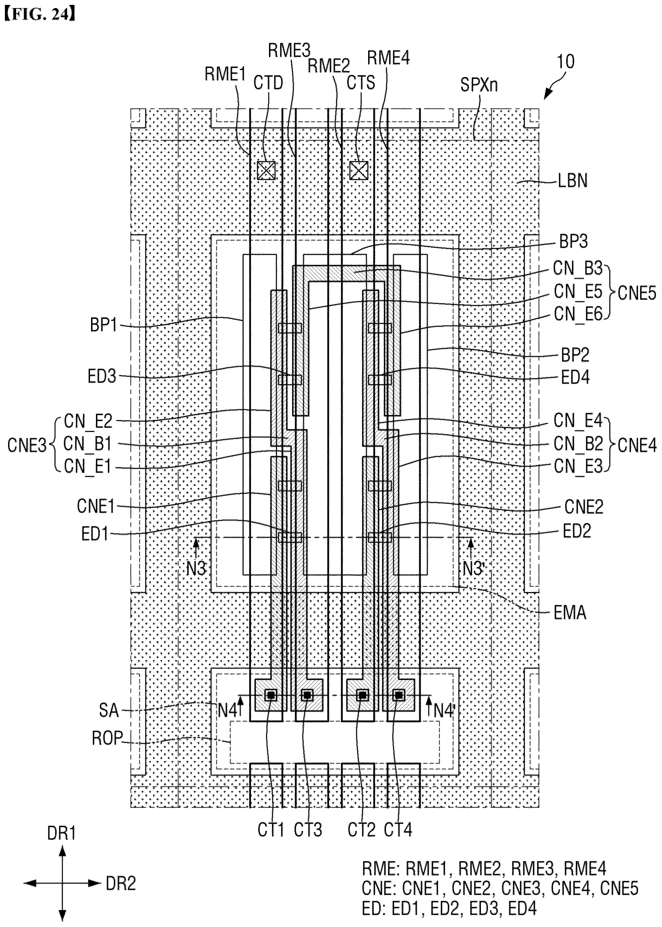

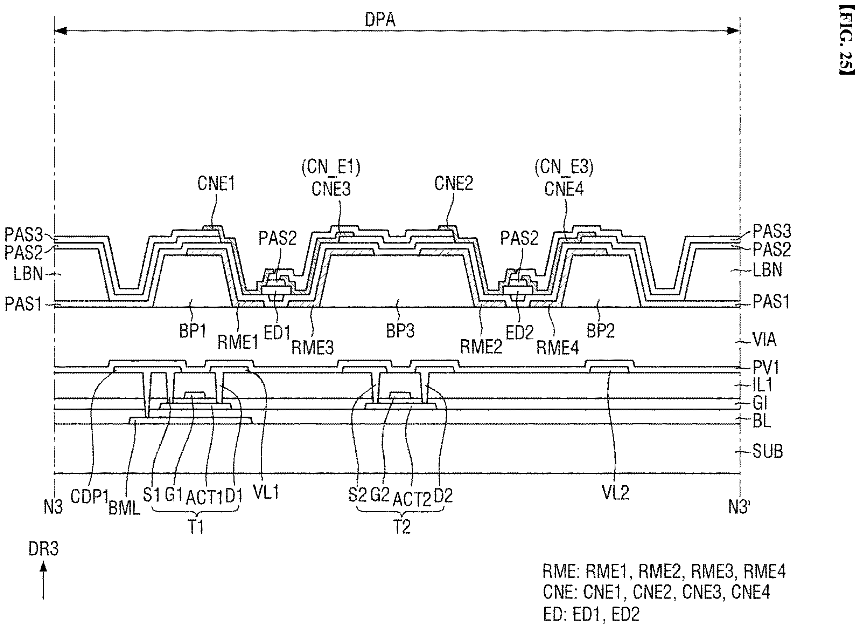

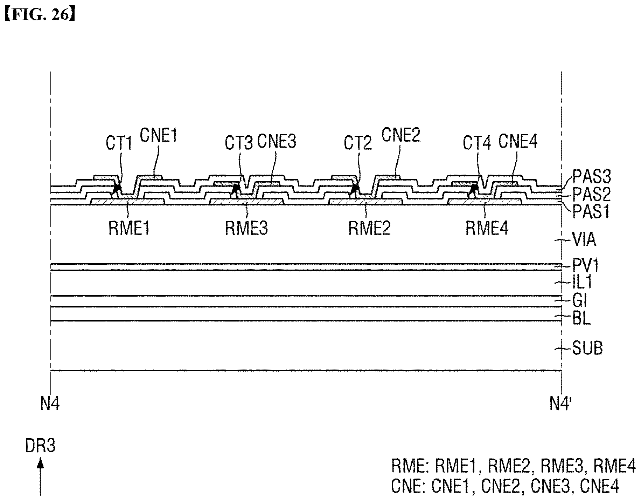

FIG. 24 is a schematic plan view illustrating a sub-pixel of a display device according to an embodiment. FIG. 25 is a schematic cross-sectional view taken along line N3-N3' of FIG. 24. FIG. 26 is a schematic cross-sectional view taken along line N4-N4' of FIG. 24.

FIG. 24 illustrates a layout, in a plan view, of electrodes RME (e.g., RME1, RME2, RME3, and RME4), bank patterns BP1, BP2, and BP3, a lower bank layer LBN, light emitting elements ED, and connection electrodes CNE (e.g., CNE1, CNE2, CNE3, CNE4, and CNE5) disposed in a pixel PX of a display device 10. FIG. 25 illustrates a cross section crossing both ends of the light emitting elements ED (e.g., ED1, ED2, ED3, and ED4) disposed on different electrodes RME, and FIG. 26 illustrates a cross section crossing contact parts CT1, CT2, CT3, and CT4.

Referring to FIGS. 24 to 26, the display device 10 according to an embodiment may include larger numbers of electrodes RME (e.g., RME1, RME2, RME3, and RME4), bank patterns BP1, BP2, and BP3, light emitting elements ED (e.g., ED1, ED2, ED3, and ED4), and connection electrodes CNE (e.g., CNE1, CNE2, CNE3, CNE4, and CNE5). The display device 10 according to an embodiment is different from the display device 10 according to an embodiment of FIG. 4 in that it includes larger numbers of electrodes and light emitting elements for each sub-pixel SPXn. Hereinafter, a description of contents repeating those described above will be omitted, and contents different from those described above will be described for descriptive convenience.

The bank patterns BP1, BP2, and BP3 may further include a third bank pattern BP3 disposed between the first bank pattern BP1 and the second bank pattern BP2. The first bank pattern BP1 may be disposed on the left side of the center of the emission area EMA, the second bank pattern BP2 may be disposed on the right side of the center of the emission area EMA, and the third bank pattern BP3 may be disposed at the center of the emission area EMA. A width of the third bank pattern BP3 in the second direction DR2 may be greater than that of the first bank pattern BP1 and the second bank pattern BP2. An interval between the respective bank patterns BP1, BP2, and BP3 spaced apart from each other in the second direction DR2 may be greater than an interval between the respective electrodes RME. The first bank pattern BP1 may partially (or entirely) overlap a first electrode RME1, and the second bank pattern BP2 may partially (or entirely) overlap a fourth electrode RME4. The third bank pattern BP3 may partially (or entirely) overlap a second electrode RME2 and a third electrode RME3. For example, some portion of the respective electrodes RME may not overlap the bank patterns BP1, BP2, and BP3.

The electrodes RME disposed for each sub-pixel SPXn may further include the third electrode RME3 and the fourth electrode RME4, in addition to the first electrode RME1 and the second electrode RME2.

The third electrode RME3 may be disposed between the first electrode RME1 and the second electrode RME2, and the fourth electrode RME4 may be spaced apart from the third electrode RME3 in the second direction DR2 with the second electrode RME2 interposed therebetween. In the electrodes RME, the first electrode RME1, the third electrode RME3, the second electrode RME2, and the fourth electrode RME4 may be sequentially disposed from the left of the sub-pixel SPXn toward the right of the sub-pixel SPXn. The respective electrodes RME may be spaced apart from and face each other in the second direction DR2. The electrodes RME may be spaced apart from electrodes RME of another sub-pixel SPXn adjacent in the first direction DR1, in the separation part ROP of the sub-area SA.

The first electrode RME1 and the second electrode RME2 of the electrodes RME may be in contact with (e.g., in electrical contact with) the first conductive pattern CDP1 and the second voltage line VL2 through the electrode contact holes CTD and CTS disposed below the lower bank layer LBN, respectively, in case that the third electrode RME3 and the fourth electrode RME4 of the electrodes RME may not be in contact with (e.g., may not be in electrical contact with) the first conductive pattern CDP1 and the second voltage line VL2.

The first insulating layer PAS1 may be disposed in a structure similar to that of the above-described embodiments. The first insulating layer PAS1 may be entirely disposed in the display area DPA, and may cover the electrodes RME and the bank patterns BP1, BP2, and BP3.

The light emitting elements ED may be disposed between the bank patterns BP1, BP2, and BP3 or on different electrodes RME. Some portion of the light emitting elements ED may be disposed between the first bank pattern BP1 and the third bank pattern BP3, and the other portion of the light emitting elements ED may be disposed between the third bank pattern BP3 and the second bank pattern BP2. According to an embodiment, the light emitting elements ED may include a first light emitting element ED1 and a third light emitting element ED3 disposed between the first bank pattern BP1 and the third bank pattern BP3 and a second light emitting element ED2 and a fourth light emitting element ED4 disposed between the bank pattern BP3 and the second bank pattern BP2 (e.g., in a horizontal direction). Each of the first light emitting element ED1 and the third light emitting element ED3 may be disposed on the first electrode RME1 and the third electrode RME3, and each of the second light emitting element ED2 and the fourth light emitting element ED4 may be disposed on the second electrode RME2 and the fourth electrode RME4. The first light emitting element ED1 and the second light emitting element ED2 may be disposed adjacent to the lower side in the emission area EMA of the corresponding sub-pixel SPXn or the sub-area SA, and the third light emitting element ED3 and the fourth light emitting element ED4 may be disposed adjacent to the upper side in the emission area EMA of the corresponding sub-pixel SPXn.

However, the respective light emitting elements ED may not be divided according to positions at which they are disposed in the emission area EMA, and may be divided according to connection relationships with connection electrodes CNE as described below. The respective light emitting elements ED may be in contact with (e.g., in electrical contact with) different connection electrodes CNE at both ends thereof according to arrangement structures of the connection electrodes CNE, and may be divided into different light emitting elements ED according to types of connection electrodes CNE with which they are in contact (e.g., in electrical contact).

The connection electrodes CNE may further include a third connection electrode CNE3, a fourth connection electrode CNE4, and a fifth connection electrode CNE5 disposed over the electrodes RME, in addition to the first connection electrode CNE1 disposed on the first electrode RME1 and the second connection electrode CNE2 disposed on the second electrode RME2.

Compared to the embodiment of FIGS. 4 to 6, a length at which each of the first connection electrode CNE1 and the second connection electrode CNE2 of FIGS. 24 to 26 extends in the first direction DR1 may be relatively short. The first connection electrode CNE1 and the second connection electrode CNE2 may be disposed on the lower side with respect to the center of the emission area EMA. The first connection electrode CNE1 and the second connection electrode CNE2 may be disposed over the emission area EMA and the sub-area SA of the corresponding sub-pixel SPXn, and may be in direct contact with the electrodes RME through the contact parts CT1 and CT2 formed in the sub-area SA, respectively. The first connection electrode CNE1 may be in direct contact with the first electrode RME1 through a first contact part CT1 penetrating through the first insulating layer PAS1, the second insulating layer PAS2, and the third insulating layer PAS3 in the sub-area SA, and the second connection electrode CNE2 may be in direct contact with the second electrode RME2 through a second contact part CT2 penetrating through the first insulating layer PAS1, the second insulating layer PAS2, and the third insulating layer PAS3 in the sub-area SA.

The third connection electrode CNE3 may include a first extension part CN_E1 disposed on the third electrode RME3, a second extension part CN_E2 disposed on the first electrode RME1, and a first connection part CN_B1 connecting the first extension part CN_E1 and the second extension part CN_E2 to each other. The first extension part CN_E1 may be spaced apart from and face the first connection electrode CNE1 in the second direction DR2, and the second extension part CN_E2 may be spaced apart from the first connection electrode CNE1 in the first direction DR1. The first extension part CN_E1 may be disposed on the lower side of the emission area EMA of the corresponding sub-pixel SPXn, and the second extension part CN_E2 may be disposed on the upper side of the emission area EMA of the corresponding sub-pixel SPXn. The first extension part CN_E1 and the second extension part CN_E2 may be disposed in the emission area EMA. The first connection part CN_B1 may be disposed over the first electrode RME1 and the third electrode RME3 at a central portion of the emission area EMA. The third connection electrode CNE3 may substantially have a shape extending in the first direction DR1, but may have a shape that is bent in the second direction DR2, and then extends again in the first direction DR1.

The fourth connection electrode CNE4 may include a third extension part CN_E3 disposed on the fourth electrode RME4, a fourth extension part CN_E4 disposed on the second electrode RME2, and a second connection part CN_B2 connecting the third extension part CN_E3 and the fourth extension part CN_E4 to each other. The third extension part CN_E3 may be spaced apart from and face the second connection electrode CNE2 in the second direction DR2, and the fourth extension part CN_E4 may be spaced apart from the second connection electrode CNE2 in the first direction DR1. The third extension part CN_E3 may be disposed on the lower side of the emission area EMA of the corresponding sub-pixel SPXn, and the fourth extension part CN_E4 may be disposed on the upper side of the emission area EMA of the corresponding sub-pixel SPXn. The third extension part CN_E3 and the fourth extension part CN_E4 may be disposed in the emission area EMA. The second connection part CN_B2 may be adjacent to the center of the emission area EMA, and be disposed over the second electrode RME2 and the fourth electrode RME4. The fourth connection electrode CNE4 may substantially have a shape extending in the first direction DR1, but may have a shape that is bent in the second direction DR2, and then extends again in the first direction DR1.

The fifth connection electrode CNE5 may include a fifth extension part CN_E5 disposed on the third electrode RME3, a sixth extension part CN_E6 disposed on the fourth electrode RME4, and a third connection part CN_B3 connecting the fifth extension part CN_E5 and the sixth extension part CN_E6 to each other. The fifth extension part CN_E5 may be spaced apart from and face the second extension part CN_E2 of the third connection electrode CNE3 in the second direction DR2, and the sixth extension part CN_E6 may be spaced apart from and face the fourth extension part CN_E4 of the fourth connection electrode CNE4 in the second direction DR2. Each of the fifth extension part CN_E5 and the sixth extension part CN_E6 may be disposed on the upper side of the emission area EMA, and the third connection part CN_B3 may be disposed over the third electrode RME3, the second electrode RME2, and the fourth electrodes RME4. The fifth connection electrode CNE5 may surround (or be adjacent to) the fourth extension part CN_E4 of the fourth connection electrode CNE4 in a plan view.

The third connection electrode CNE3 may be in direct contact with the third electrode RME3 through a third contact part CT3 penetrating through the first insulating layer PAS1 and the second insulating layer PAS2 in the sub-area SA, and the fourth connection electrode CNE4 may be in direct contact with the fourth electrode RME4 through a fourth contact part CT4 penetrating through the first insulating layer PAS1 and the second insulating layer PAS2 in the sub-area SA.

However, embodiments are not limited thereto. In some embodiments, in the display device 10, some portion of the connection electrodes CNE may be connected to (e.g., directly connected to) the third conductive layer. For example, each of the first connection electrode CNE1 and the second connection electrode CNE2, which are first-type connection electrodes, may be connected to (e.g., directly connected to) the third conductive layer, and may not be electrically connected to the electrode RME. A second-type connection electrode and a third-type connection electrode may also not be electrically connected to the electrode RME, and may be connected only to (e.g., electrically connected only to) the light emitting elements ED.

The first connection electrode CNE1 and the second connection electrode CNE2 may be the first-type connection electrodes connected to (e.g., electrically connected to) the electrodes RME1 and RME2 that are connected to (e.g., directly connected to) the third conductive layer, respectively, the third connection electrode CNE3 and the fourth connection electrode CNE4 may be the second-type connection electrodes connected to (e.g., electrically connected to) the electrodes RME3 and RME4 that are not connected to the third conductive layer, and the fifth connection electrode CNE5 may be the third-type connection electrode that is not connected to the electrode RME. The fifth connection electrode CNE5 may not be connected to the electrode RME, and may be in contact with (e.g., in electrical contact with) the light emitting elements ED and may constitute an electrical connection circuit of the light emitting elements ED together with the other connection electrodes CNE.

The third connection electrode CNE3 and the fourth connection electrode CNE4, which are the second-type connection electrodes, may be connection electrodes of which electrode extension parts extending in the first direction DR1 are not in parallel with each other in the second direction DR2, and the fifth connection electrode CNE5, which is the third-type connection electrode, may be a connection electrode of which electrode extension parts extending in the first direction DR1 are in substantially parallel with each other in the second direction DR2. The third connection electrode CNE3 and the fourth connection electrode CNE4 may have a shape extending in the first direction DR1, but are bent, and the fifth connection electrode CNE5 may have a shape surrounding a portion of the other connection electrode.

The light emitting elements ED may be divided or defined into different-type light emitting elements ED according to the connection structure (or the arrangement structure) between the connection electrodes CNE and both ends of the light emitting elements ED. The first light emitting element ED1 and the second light emitting element ED2 may have first ends contacting the first-type connection electrodes and second ends contacting the second-type connection electrodes. The first light emitting element ED1 may be in contact with (e.g., in electrical contact with) the first connection electrode CNE1 and the third connection electrode CNE3, and the second light emitting element ED2 may be in contact with (e.g., in electrical contact with) the second connection electrode CNE2 and the fourth connection electrode CNE4. The third light emitting element ED3 and the fourth light emitting element ED4 may have first ends contacting the second-type connection electrodes and second ends contacting the third-type connection electrodes. The third light emitting element ED3 may be in contact with (e.g., in electrical contact with) the third connection electrode CNE3 and the fifth connection electrode CNE5, and the fourth light emitting element ED4 may be in contact with (e.g., in electrical contact with) the fourth connection electrode CNE4 and the fifth connection electrode CNE5.

The light emitting elements ED may be connected to (e.g., electrically connected to) each other in series through the connection electrodes CNE. The display device 10 according to an embodiment may include the larger number of light emitting elements ED for each sub-pixel SPXn, and the series connection between the light emitting elements may be configured, such that an amount of light emitted per unit area may be further increased.

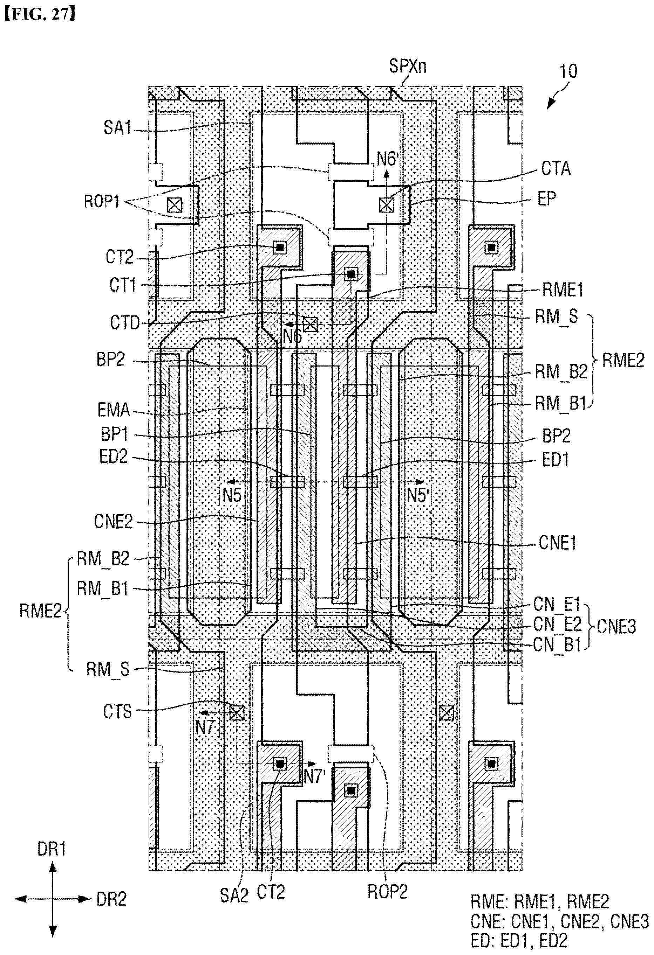

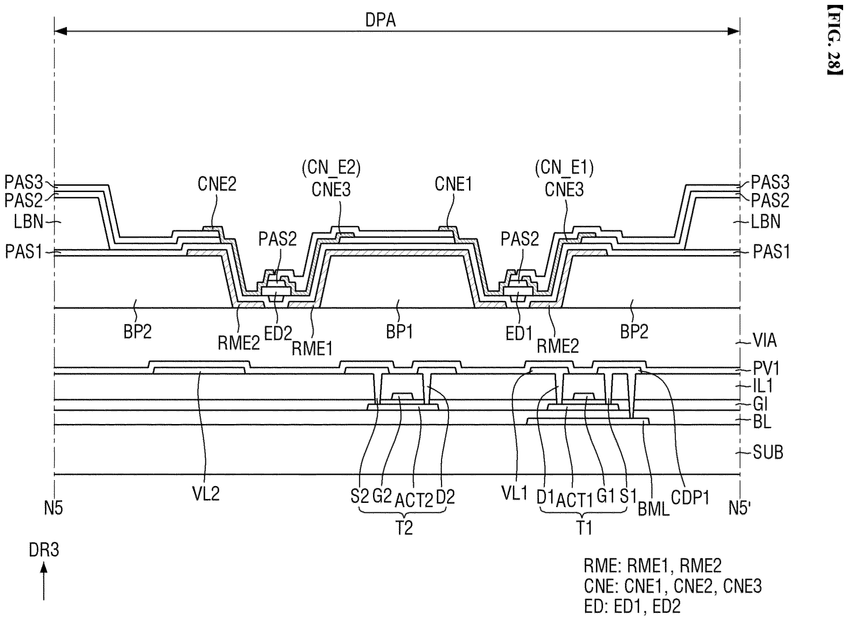

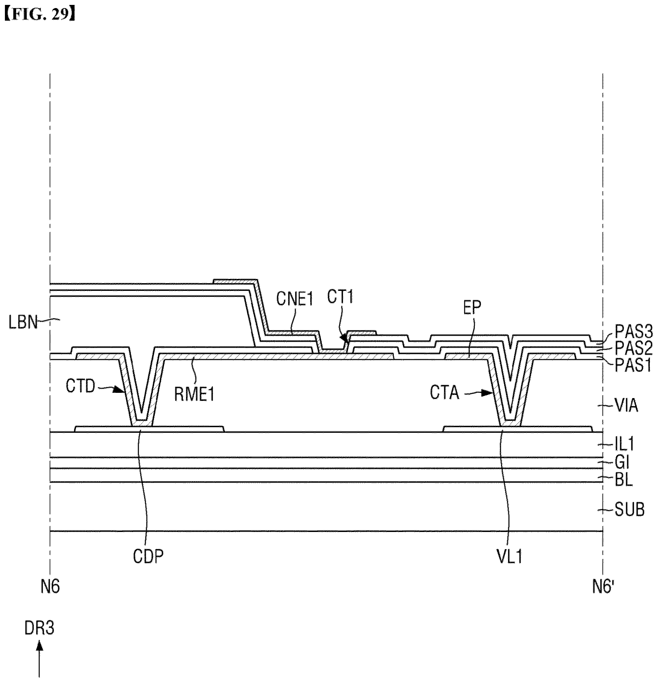

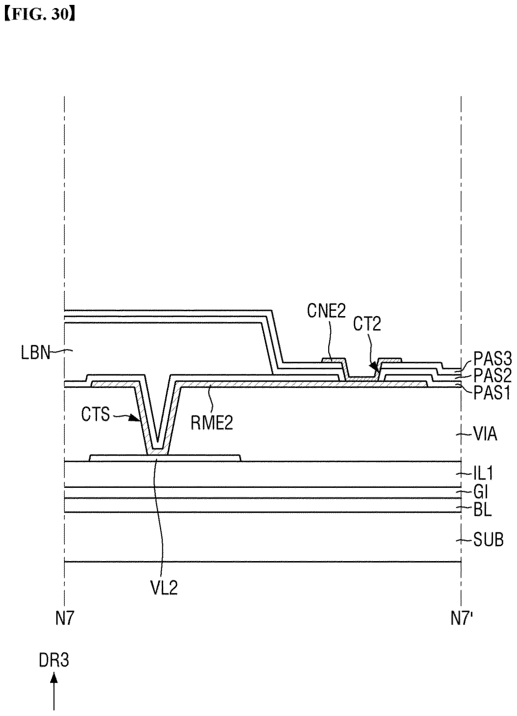

FIG. 27 is a schematic plan view illustrating a sub-pixel of a display device according to an embodiment. FIG. 28 is a schematic cross-sectional view taken along line N5-N5' of FIG. 27. FIG. 29 is a schematic cross-sectional view taken along line N6-N6' of FIG. 27. FIG. 30 is a schematic cross-sectional view taken along line N7-N7' of FIG. 27.

FIG. 27 illustrates a layout, in a plan view, of electrodes RME (e.g., RME1 and RME2), bank patterns BP1 and BP2, a lower bank layer LBN, light emitting elements ED, and connection electrodes CNE (e.g., CNE1, CNE2, and CNE3) disposed in a pixel PX of a display device 10. FIG. 28 illustrates a cross section crossing both ends of the light emitting elements ED (e.g., ED1 and ED2) disposed on different electrodes RME. FIGS. 29 and 30 illustrate cross sections crossing electrode contact holes CTD, CTS, and CTA, and contact parts CT1 and CT2.

Referring to FIGS. 27 to 30, the display device 10 according to an embodiment may be different from the display devices 10 according to the above-described embodiments in structures of the electrodes RME, the connection electrodes CNE, and the bank patterns BP1 and BP2. Hereinafter, a description of contents repeating those of above-described embodiments will be omitted, and contents different from those of above-described embodiments will be described for descriptive convenience.

The bank patterns BP1 and BP2 may have a shape extending in the first direction DR1, but widths of the bank patterns BP1 and BP2 in the second direction DR2 may be different from each other, and any one of the bank patterns BP1 and BP2 may be disposed over the sub-pixels SPXn neighboring to each other in the second direction DR2. For example, the bank patterns BP1 and BP2 may include a first bank pattern BP1 disposed in the emission area EMA of each sub-pixel SPXn and a second bank pattern BP2 disposed over the emission areas EMA of the different sub-pixels SPXn.

The first bank pattern BP1 may be disposed at a central portion of the emission area EMA, and the second bank patterns BP2 may be spaced apart from the first bank pattern BP1 with the first bank pattern BP1 therebetween. The first bank patterns BP1 and the second bank patterns BP2 may be alternately disposed along the second direction DR2. The light emitting elements ED may be disposed between the first bank pattern BP1 and the second bank patterns BP2 spaced apart from each other.

The first bank pattern BP1 and the second bank pattern BP2 may have the same length in the first direction DR1, but may have different widths in the second direction DR2. A portion of the lower bank layer LBN extending in the first direction DR1 may overlap the second bank pattern BP2 in the thickness direction. The first bank pattern BP1 may overlap a first electrode RME1, and the second bank pattern BP2 may overlap electrode branch parts RM_B1 and RM_B2 of a second electrode RME2 and the lower bank layer LBN.

The first bank pattern BP1 and the second bank pattern BP2 may have the same length in the first direction DR1, but may have different widths in the second direction DR2. A portion of the lower bank layer LBN extending in the first direction DR1 may overlap the second bank pattern BP2 in the thickness direction. The bank patterns BP1 and BP2 may be disposed as island-shaped patterns in the entirety of the display area DPA.

Electrodes RME may include the first electrode RME1 disposed at a central portion of each sub-pixel SPXn and the second electrodes RME2 disposed over the different sub-pixels SPXn. The first electrode RME1 and the second electrode RME2 may substantially have a shape extending in the first direction DR1, but portions of the first electrode RME1 and the second electrode RME2 disposed in the emission area EMA may have different shapes.

The first electrode RME1 may be disposed at the center of the sub-pixel SPXn, and a portion of the first electrode RME1 disposed in the emission area EMA may be disposed on the first bank pattern BP1. The first electrode RME1 may extend from the sub-area SA in the first direction DR1 and extend to the sub-area SA of another sub-pixel SPXn. The first electrode RME1 may have a shape in which a width thereof in the second direction DR2 varies according to positions, and at least a portion of the first electrode RME1 overlapping the first bank pattern BP1 in the emission area EMA may have a greater width than the first bank pattern BP1.

The second electrode RME2 may include a portion extending in the first direction DR1 and portions branched in the vicinity of the emission area EMA. In an embodiment, the second electrode RME2 may include an electrode stem part RM_S extending in the first direction DR1 and electrode branch parts RM_B1 and RM_B2 branched from the electrode stem part RM_S, bent in the second direction DR2, and then extending again in the first direction DR1. The electrode stem part RM_S may overlap a portion of the lower bank layer LBN extending in the first direction DR1, and may be disposed on one side of the sub-area SA in the second direction DR2. The electrode branch parts RM_B1 and RM_B2 may be branched from the electrode stem part RM_S disposed at a portion of the lower bank layer LBN extending in the first direction DR1 and a portion of the lower bank layer LBN extending in the second direction DR2, and be bent to both sides in the second direction DR2, respectively. The electrode branch parts RM_B1 and RM_B2 may cross the emission area EMA in the first direction DR1, may be bent again. For example, the electrode branch parts RM_B1 and RM_B2 and the electrode stem part RM_S may be integral with each other to be connected to (e.g., electrically connected to) each other. For example, the electrode branch parts RM_B1 and RM_B2 of the second electrode RME2 may be branched on the upper side of the emission area EMA of any one sub-pixel SPXn, and then connected to (e.g., electrically connected to) each other again on the lower side of the emission area EMA.

The second electrode RME2 may include a first electrode branch part RM_B1 disposed on the left side of the first electrode RME1 and a second electrode branch part RM_B2 disposed on the right side of the first electrode RME1. The electrode branch parts RM_B1 and RM_B2 included in a second electrode RME2 may be disposed in the emission areas EMA of the sub-pixels SPXn neighboring to (or adjacent to) each other in the second direction DR2, respectively, and the electrode branch parts RM_B1 and RM_B2 of different second electrodes RME2 may be disposed in a sub-pixel SPXn. The first electrode branch part RM_B1 of a second electrode RME2 may be disposed on the left side of the first electrode RME1, and the second electrode branch part RM_B2 of the other second electrode RME2 may be disposed on the right side of the first electrode RME1.

The respective electrode branch parts RM_B1 and RM_B2 of the second electrodes RME2 may overlap a side of the second bank patterns BP2. The first electrode branch part RM_B1 may partially overlap the second bank pattern BP2 disposed on the left side of the first bank pattern BP1, and the second electrode branch part RM_B2 may partially overlap the second bank pattern BP2 disposed on the right side of the first bank pattern BP1. Both sides of the first electrode RME1 may be spaced apart from and face different electrode branch parts RM_B1 and RM_B2 of different second electrodes RME2, and an interval (or gap) between the first electrode RME1 and the respective electrode branch parts RM_B1 and RM_B2 may be smaller than an interval (or gap) between different bank patterns BP1 and BP2.

A width of the first electrode RME1 in the second direction DR2 may be greater than those of the electrode stem part RM_S and the electrode branch parts RM_B1 and RM_B2 of the second electrode RME2. The first electrode RME1 has a width greater than that of the first bank pattern BP1 and overlaps both sides of the first bank pattern BP1, in case that the second electrodes RME2 are formed to have a relatively small width, such that the electrode branch parts RM_B1 and RM_B2 may overlap only sides of the second bank patterns BP2.

The first electrode RME1 may be in contact with (e.g., in electrical contact with) the first conductive pattern CDP1 of the third conductive layer through a first electrode contact hole CTD at a portion thereof overlapping a portion of the lower bank layer LBN extending in the second direction DR2. The second electrode RME2 may also be in contact with (e.g., in electrical contact with) the second voltage line VL2 of the third conductive layer through a second electrode contact hole CTS at the electrode stem part RM_S. The first electrode RME1 may overlap a first contact part CT1 at a portion thereof disposed in the sub-area SA, and the second electrode RME2 may include a portion protruding from the electrode stem part RM_S in the second direction DR2 to be disposed in the sub-area SA and may overlap a second contact part CT2 at the protruding portion.

Among the first electrode RME1 and the second electrode RME2, the first electrode RME1 may extend to separation parts ROP1 and ROP2 of the sub-areas SA, whereas the second electrode RME2 may not be separated in the sub-area SA by separation parts ROP1 and ROP2. One second electrode RME2 may have a shape extending in the first direction DR1 and branched in the vicinity of the emission area EMA of each sub-pixel SPXn by including electrode stem parts RM_S and electrode branch parts RM_B1 and RM_B2. The first electrode RME1 may be disposed between the separation parts ROP1 and ROP2 disposed in different sub-areas SA1 and SA2 of each sub-pixel SPXn, and may cross the emission area EMA.

According to an embodiment, the display device 10 may include a line connection electrode EP disposed in a first sub-area SA1 of sub-areas SA1 and SA2 of each sub-pixel SPXn to be disposed between the first electrodes RME1 of different sub-pixels SPXn. In the second sub-area SA of the sub-pixel SPXn, the line connection electrode EP may not be disposed, and the first electrodes RME1 of the different sub-pixels SPXn adjacent to each other in the first direction DR1 may be spaced apart from each other. In the sub-pixel SPXn of FIG. 27 among the sub-pixels SPXn, the first sub-area SA1, in which the line connection electrode EP is disposed, may be disposed on the upper side of the emission area EMA, and the second sub-area SA2 may be disposed on the lower side of the emission area EMA. For example, in a sub-pixel SPXn adjacent to the sub-pixel SPXn of FIG. 27 in the first direction DR1, the first sub-area SA1, in which the line connection electrode EP is disposed, may be disposed on the lower side of the emission area EMA, and the second sub-area SA2 may be disposed on the upper side of the emission area EMA.

The first electrode RME1 may be spaced apart from the line connection electrode EP with the first separation part ROP1 interposed therebetween in the first sub-area SA1. In one first sub-area SA1, two first separation parts ROP1 may be disposed, and the line connection electrode EP may be spaced apart from the first electrode RME1 disposed in the corresponding sub-pixel SPXn with a first separation part ROP1 on the lower side interposed therebetween and be spaced apart from the first electrode RME1 disposed in another sub-pixel SPXn with a first separation part ROP1 on the upper side interposed therebetween. In the second sub-area SA2, one second separation part ROP2 may be disposed, and different first electrodes RME1 may be spaced apart from each other in the first direction DR1.

In an embodiment, the line connection electrode EP may be connected to (e.g., electrically connected to) the first voltage line VL1 of the third conductive layer through a third electrode contact hole CTA penetrating through the via layer VIA. The first electrode RME1 may be formed in a state in which it is connected to (e.g., electrically connected to) the line connection electrode EP, and an electrical signal applied in order to dispose the light emitting elements ED may be applied from the first voltage line VL1 to the first electrode RME1 through the line connection electrode EP. In a process of disposing the light emitting elements ED, signals may be applied to the first voltage line VL1 and the second voltage line VL2, and be transferred to the first electrode RME1 and the second electrode RME2, respectively.

For example, the second electrode contact hole CTS may have a relative arrangement different from that of a third electrode contact hole CTA as described below. The second electrode contact hole CTS may be disposed in a portion of the lower bank layer LBN surrounding the second sub-area SA2, and the third electrode contact hole CTA may be disposed in the first sub-area SA1. The second electrode contact hole CTS and the third electrode contact hole CTA may expose upper surfaces of different voltage lines VL1 and VL2, respectively, and accordingly, positions of the second electrode contact hole CTS and the third electrode contact hole CTA may be determined.

The lower bank layer LBN may surround the emission area EMA and the sub-areas SA1 and SA2, similar to the above-described embodiment. However, in an embodiment in which the display device 10 includes the sub-areas SA1 and SA2 divided from each other, areas surrounded by the lower bank layer LBN may be divided from each other. The lower bank layer LBN is the same as that of the above-described embodiment except that it surrounds different sub-areas SA1 and SA2.

The light emitting elements ED may be disposed on different electrodes RME between different bank patterns BP1 and BP2. The light emitting elements ED may include first light emitting elements ED1 having both ends disposed on the first electrode RME1 and the second electrode branch part RM_B2 of the second electrode RME2, respectively, and second light emitting elements ED2 having both ends disposed on the first electrode RME1 and the first electrode branch part RM_B1 of the other second electrode RME2, respectively. The first light emitting elements ED1 may be disposed on the right side with respect to the first electrode RME1, and the second light emitting elements ED2 may be disposed on the left side with respect to the first electrode RME1. The first light emitting elements ED1 may be disposed on the first electrode RME1 and the second electrode RME2, and the second light emitting elements ED2 may be disposed on the first electrode RME1 and the second electrode RME2.

The connection electrodes CNE (e.g., CNE1, CNE2, and CNE3) may include a first connection electrode CNE1, a second connection electrode CNE2, and a third connection electrode CNE3.

The first connection electrode CNE1 may have a shape extending in the first direction DR1, and may be disposed on the first electrode RME1. A portion of the first connection electrode CNE1 disposed on the first bank pattern BP1 may overlap the first electrode RME1, and the first connection electrode CNE1 may extend from such a portion in the first direction DR1 to extend to the first sub-area SA1 positioned on the upper side of the emission area EMA beyond the lower bank layer LBN. The first connection electrode CNE1 may be in contact with (e.g., in electrical contact with) the first electrode RME1 through the first contact part CT1 in the first sub-area SA1.

The second connection electrode CNE2 may have a shape extending in the first direction DR1, and may be disposed on the second electrode RME2. A portion of the second connection electrode CNE2 disposed on the second bank pattern BP2 may overlap the second electrode RME2, and the second connection electrode CNE2 may extend from such a portion in the first direction DR1 to extend to the first sub-area SA1 positioned on the upper side of the emission area EMA beyond the lower bank layer LBN. The second connection electrode CNE2 may be in contact with (e.g., in electrical contact with) the second electrode RME2 through the second contact part CT2 in the first sub-area SA1.

For example, in a sub-pixel SPXn adjacent to the sub-pixel SPXn of FIG. 27 in the first direction DR1, the first connection electrode CNE1 and the second connection electrode CNE2 may be in contact with (e.g., in electrical contact with) the first electrode RME1 and the second electrode RME2 through the contact parts CT1 and CT2 disposed in the second sub-area SA2, respectively.

The third connection electrode CNE3 may include extension parts CN_E1 and CN_E2 extending in the first direction DR1 and a first connection part CN_B1 connecting the extension parts CN_E1 and CN_E2 to each other. A first extension part CN_E1 may face the first connection electrode CNE1 in the emission area EMA and may be disposed on the second electrode branch part RM_B2 of the second electrode RME2. For example, a second extension part CN_E2 may face the second connection electrode CNE2 in the emission area EMA and may be disposed on the first electrode RME1. The first connection part CN_B1 may extend in the second direction DR2 on the lower bank layer LBN disposed on the lower side of the emission area EMA to connect the first extension part CN_E1 and the second extension part CN_E2 to each other. The third connection electrode CNE3 may be disposed in the emission area EMA and on the lower bank layer LBN, and may not be directly connected to the electrodes RME. The second electrode branch part RM_B2 disposed below the first extension part CN_E1 may be connected to (e.g., electrically connected to) the second voltage line VL2, but a second source voltage applied to the second electrode branch part RM_B2 may not be transferred to the third connection electrode CNE3.

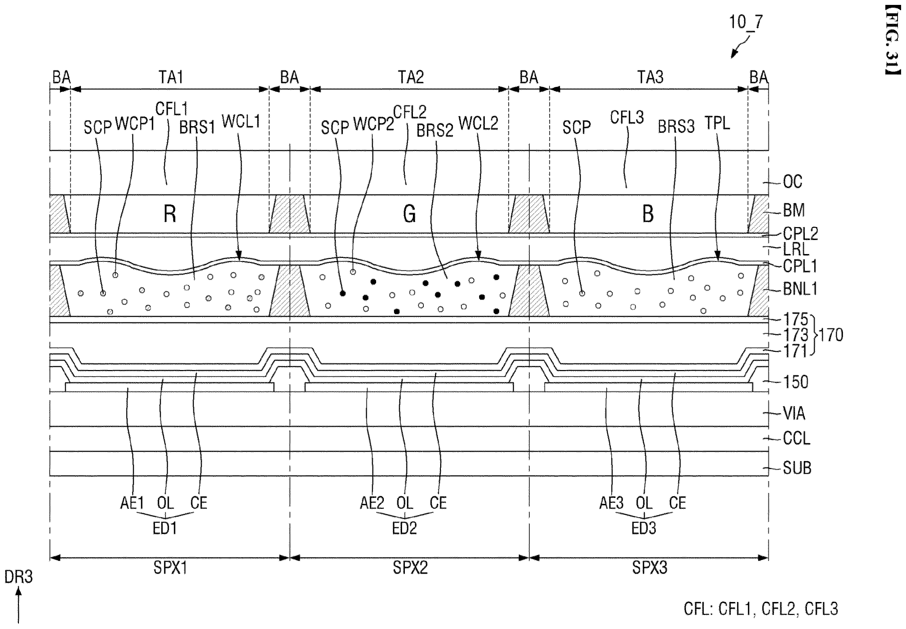

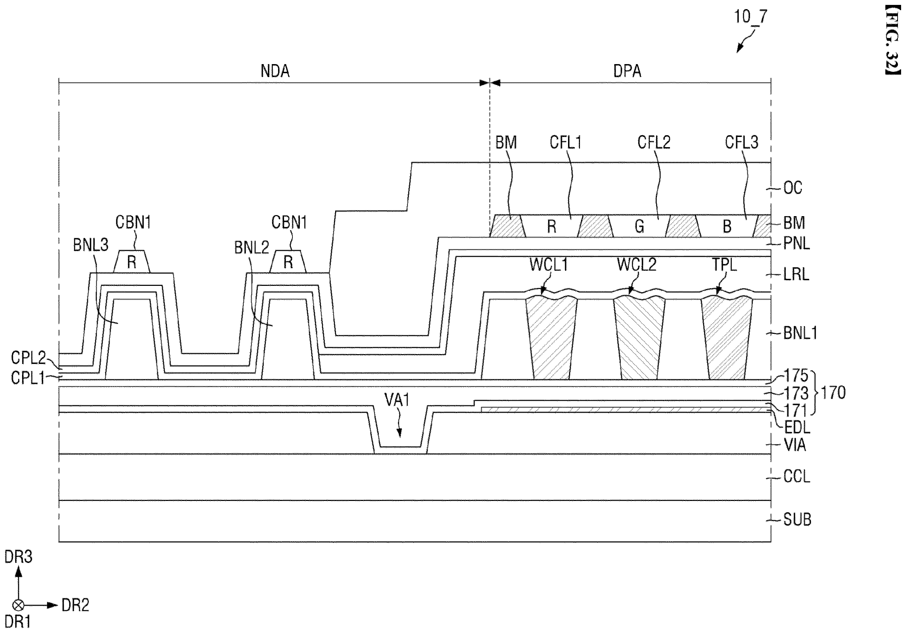

FIG. 31 is a schematic cross-sectional view of a display device according to an embodiment. FIG. 32 is a schematic cross-sectional view illustrating an outer portion of the display device of FIG. 31.

Referring to FIGS. 31 and 32, a display device 10_7 according to an embodiment may include organic light emitting elements, unlike the display device 10 described above with reference to FIGS. 2 to 6. In the display device 10_7, the bank patterns BP1 and BP2, the electrodes RME, the light emitting elements ED, and the connection electrodes CNE disposed on the via layer VIA may be replaced with other layers or electrodes. Hereinafter, a description of contents repeating the descriptions of an embodiment of FIGS. 2 to 6 will be omitted, and contents different from those of an embodiment of FIGS. 2 to 6 will be described for descriptive convenience.

The display device 10_7 may include anode electrodes AE1, AE2, and AE3, a pixel defining film 150, an organic layer OL, and a cathode electrode CE disposed on the via layer VIA. For example, the display device 10_7 may include an encapsulation layer 170 disposed on the cathode electrode CE.

The anode electrodes AE1, AE2, and AE3 may be disposed on the via layer VIA. A first anode electrode AE1 may be disposed in the first sub-pixel SPX1, a second anode electrode AE2 may be disposed in the second sub-pixel SPX2, and a third anode electrode AE3 may be disposed in the third sub-pixel SPX3.

In some embodiments, widths or areas of the first anode electrode AE1, the second anode electrode AE2, and the third anode electrode AE3 may be different from each other. For example, a width of the first anode electrode AE1 may be smaller than that of the second anode electrode AE2, and the width of the second anode electrode AE2 may be smaller than that of the first anode electrode AE1 but greater than that of the third anode electrode AE3. For example, an area of the first anode electrode AE1 may be greater than that of the second anode electrode AE2, and the area of the second anode electrode AE2 may be smaller than that of the first anode electrode AE1 but greater than that of the third anode electrode AE3. However, embodiments are not limited thereto, and the area of the first anode electrode AE1 may be smaller than that of the second anode electrode AE2, and the area of the third anode electrode AE3 may be greater than that of the second anode electrode AE2 and that of the first anode electrode AE1. In some cases, the widths or the areas of the first anode electrode AE1, the second anode electrode AE2, and the third anode electrode AE3 may also be substantially the same as each other.

The first anode electrode AE1, the second anode electrode AE2, and the third anode electrode AE3 may include a material having high reflectivity. For example, the first anode electrode AE1, the second anode electrode AE2, and the third anode electrode AE3 may be metal layers including metals such as Ag, Mg, Al, Pt, Pd, Au, Ni, Nd, Ir, Cr, or compounds or mixtures thereof. In an embodiment, the first anode electrode AE1, the second anode electrode AE2, and the third anode electrode AE3 may further include metal oxide layers stacked on the metal layers. In an embodiment, the first anode electrode AE1, the second anode electrode AE2, and the third anode electrode AE3 may have a two-layer structure such as ITO/Ag, Ag/ITO, ITO/Mg, or ITO/MgF, or a multilayer structure such as ITO/Ag/ITO.

The pixel defining film 150 may be disposed on the first anode electrode AE1, the second anode electrode AE2, and the third anode electrode AE3. The pixel defining film 150 may include an opening exposing the first anode electrode AE1, an opening exposing the second anode electrode AE2, and an opening exposing the third anode electrode AE3.

In some examples, the pixel defining film 150 may include an organic insulating material such as a polyacrylates resin, an epoxy resin, a phenolic resin, a polyamides resin, a polyimides resin, an unsaturated polyesters resin, a polyphenyleneethers resin, a polyphenylenesulfides resin, or benzocyclobutene (BCB).

The organic layer OL may be disposed on the first anode electrode AE1, the second anode electrode AE2, and the third anode electrode AE3. In some embodiments, the organic layer OL may have a shape of a continuous film formed over sub-pixels SPXn and boundaries between the sub-pixels SPXn.

The cathode electrode CE may be disposed on the organic layer OL. In some embodiments, the cathode electrode CE may have transflective properties or transmissive properties. In case that the cathode electrode CE has the transflective properties, the cathode electrode CE may include Ag, Mg, Cu, Al, Pt, Pd, Au, Ni, Nd, Ir, Cr, Li, Ca, LiF/Ca, LiF/Al, Mo, Ti, or compounds or mixtures thereof, for example, a mixture of Ag and Mg. For example, in case that a thickness of the cathode electrode CE is several tens to several hundreds of angstroms, the cathode electrode CE may have the transflective properties.

In case that the cathode electrode CE has the transmissive properties, the cathode electrode CE may include transparent conductive oxide (TCO). For example, the cathode electrode CE may include tungsten oxide (WₓOₓ), titanium oxide (TiO₂), indium tin oxide (ITO), indium zinc oxide (IZO), zinc oxide (ZnO), indium tin zinc oxide (ITZO), magnesium oxide (MgO), or the like.

The first anode electrode AE1, the organic layer OL, and the cathode electrode CE may constitute a first organic light emitting element ED1, the second anode electrode AE2, the organic layer OL, and the cathode electrode CE may constitute a second organic light emitting element ED2, and the third anode electrode AE3, the organic layer OL, and the cathode electrode CE may constitute a third organic light emitting element ED3. Light emitted from the respective organic light emitting elements ED1, ED2, and ED3 may be incident on color control members TPL, WCL1 and WCL2 disposed above the organic light emitting elements ED1, ED2, and ED3.

The encapsulation layer 170 may be disposed on the light emitting elements ED so as to cover the third insulating layer PAS3 and the connection electrodes CNE1 and CNE2. The encapsulation layer 170 may be substantially entirely disposed on the first substrate SUB, and may completely cover members disposed on the first substrate SUB.

The encapsulation layer 170 may include a first encapsulation layer 171, a second encapsulation layer 173, and a third encapsulation layer 175 sequentially stacked on the third insulating layer PAS3. The first encapsulation layer 171 and the third encapsulation layer 175 may include an inorganic insulating material, and the second encapsulation layer 173 may include an organic insulating material. For example, each of the first encapsulation layer 171 and the third encapsulation layer 175 may include at least one of silicon nitride, aluminium nitride, zirconium nitride, titanium nitride, hafnium nitride, tantalum nitride, silicon oxide, aluminium oxide, titanium oxide, tin oxide, cerium oxide, silicon oxynitride (SiOₓN_{y}), and lithium fluoride. The second encapsulation layer 173 may include at least one of an acrylic resin, a methacrylic resin, polyisoprene, a vinyl resin, an epoxy resin, a urethane resin, a cellulose resin, and a perylene resin. However, a stacked structure and materials of the encapsulation layer 170 are not limited to those described above, and may be variously modified.

Each of the first bank BNL1 and the color control members TPL, WCL1, and WCL2 may be disposed on the encapsulation layer 170. The first bank BNL1 may be disposed on the encapsulation layer 170 so as to overlap the pixel defining film 150, and the color control members TPL, WCL1 and WCL2 may be disposed in areas surrounded by the first bank BNL1 on the encapsulation layer 170. The capping layers CPL1 and CPL2, the low refraction layer LRL, the planarization layer PNL, the light blocking member BM, the color filter layers CFL, and the overcoat layer OC as described above may be disposed on the first bank BNL1 and the color control members TPL, WCL1, and WCL2.

In an embodiment in which the display device 10_7 includes the organic light emitting elements ED1, ED2, and ED3, each of the second bank BNL2 and the third bank BNL3 of the non-display area NDA may be directly disposed on the third encapsulation layer 175 of the encapsulation layer 170. The first encapsulation layer 171 may be directly disposed on inner sidewalls of the first valley part VA1 disposed between the first bank BNL1 and the second bank BNL2, and a step due to the first valley part VA1 may be filled by the second encapsulation layer 173. For example, a portion of the first capping layer CPL1 may be directly disposed on the third encapsulation layer 175 of the encapsulation layer 170. However, embodiments are not limited thereto.

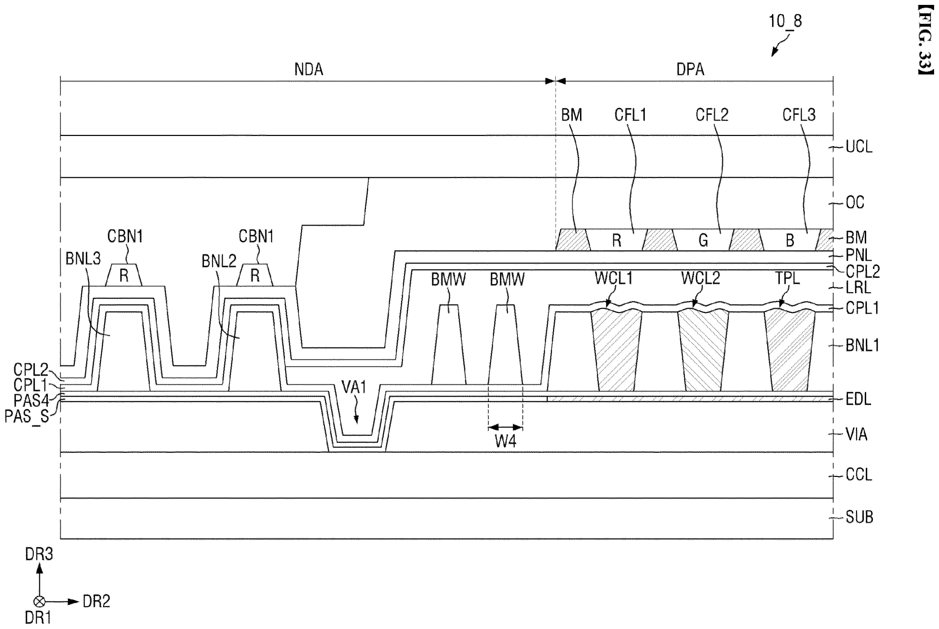

FIG. 33 is a schematic cross-sectional view illustrating an outer portion of a display device according to an embodiment.

Referring to FIG. 33, a display device 10_8 according to an embodiment may further include an upper cover layer UCL disposed on the overcoat layer OC. The upper cover layer UCL may be disposed at the uppermost layer of the display device 10_8 to protect the display device 10_8 from external impact or perform an optical function for light emitted from the display device 10_8 or incident from the outside. As an example, the upper cover layer UCL may be an optical film preventing a decrease in visibility due to reflection of external light. In an embodiment in which the upper cover layer UCL is the optical film, the upper cover layer UCL may include a phase difference retardation film and a coating layer protecting the phase difference retardation film. The upper cover layer UCL may include a layer made of a cellulose resin such as triacetyl cellulose, a polyester resin, or the like, but is not limited thereto.

The upper cover layer UCL may be disposed in the display area DPA and the non-display area NDA of the display device 10_8 on the overcoat layer OC. The upper cover layer UCL may have an area similar to that of the first substrate SUB in a plan view, and may completely cover the display area DPA and the non-display area NDA as illustrated in FIG. 33. However, embodiments are not limited thereto, and the upper cover layer UCL may cover only the display area DPA or cover the display area DPA and only a portion of the non-display area NDA.

In an embodiment in which the upper cover layer UCL is disposed to completely cover the non-display area NDA, a space may be formed below the upper cover layer UCL. A portion where the second bank BNL2 and the third bank BNL3 are disposed at the outermost portion of the display device 10_8 may have a lower height than the overcoat layer OC, and a space may be formed between the upper cover layer UCL and the second and third banks BNL2 and BNL3. The space may be filled with a filling material, but is not limited thereto. The filling material may not be filled in the space below the upper cover layer UCL, and an air layer may be formed in the space below the upper cover layer UCL.

In concluding the detailed description, those skilled in the art will appreciate that many variations and modifications may be made to the embodiments without substantially departing from the principles of the disclosure. Therefore, the disclosed embodiments are used in a generic and descriptive sense only and not for purposes of limitation.

## Claims

1. A display device comprising:
a first substrate including a display area and a non-display area surrounding the display area;
a plurality of sub-pixels including a plurality of light emitting elements disposed on the first substrate in the display area;
a first bank surrounding the sub-pixels in the display area;
a plurality of color control members in an area surrounded by the first bank on the light emitting elements of the plurality of sub-pixels;
a plurality of color filter layers disposed on the color control members;
a second bank spaced apart from the first bank and surrounding the display area in the non-display area; and
a plurality of color dams disposed on the second bank, wherein
the color dams include:
a first color dam disposed on a first portion of the second bank disposed on a first side of the display area, and
a second color dam disposed on a second portion of the second bank disposed on a second side of the display area opposite to the first side of the display area, and
the first color dam and the second color dam include different materials.

2. The display device of claim 1, wherein
the plurality of sub-pixels include a first sub-pixel and a second sub-pixel spaced apart from the first sub-pixel in a direction,
the plurality of color control members include a first wavelength conversion layer disposed in the first sub-pixel and a light transmitting layer disposed in the second sub-pixel, and
the plurality of color filter layers include a first color filter layer disposed on the first wavelength conversion layer and a second color filter layer disposed on the light transmitting layer.

3. The display device of claim 2, wherein
the first color dam and the second color dam are spaced apart from each other in the direction,
the display area is disposed between the first color dam and the second color dam,
the first color dam and the first color filter layer include a same material, and
the second color dam and the second color filter layer include a same material.

4. The display device of claim 3, wherein
the sub-pixels further include a third sub-pixel disposed between the first sub-pixel and the second sub-pixel,
the plurality of color control members further include a second wavelength conversion layer disposed in the third sub-pixel,
the plurality of color filter layers further include a third color filter layer disposed on the second wavelength conversion layer,
the display device further comprising a third color dam disposed on the first color dam, and
the third color dam and the third color filter layer include a same material.

5. The display device of claim 4, wherein
a width of the third color dam is greater than a width of the first color dam, and
an outer surface of the first color dam is covered by the third color dam.

6. The display device of claim 4, further comprising a plurality of color patterns overlapping the first bank, wherein
the color patterns include:
a first color pattern, the first color pattern and the first color filter layer including a same material,
a second color pattern, the second color pattern and the second color filter layer including a same material, and
a third color pattern, the third color pattern and the third color filter layer including a same material, and
the first color pattern overlaps each of the second color filter layer and the third color filter layer in a plan view.

7. The display device of claim 2, wherein
the first color dam and the second color dam are spaced apart from each other in the direction,
the display area is disposed between the first color dam and the second color dam,
the first color dam and the second color filter layer include a same material, and
the second color dam and the first color filter layer include a same material.

8. The display device of claim 1, further comprising:
a first capping layer disposed on the plurality of color control members, the first bank, and the second bank;
a low refraction layer disposed on the first capping layer; and
a second capping layer disposed on the low refraction layer,
wherein the first color dam and the second color dam are disposed on the second capping layer.

9. The display device of claim 8, further comprising a planarization layer disposed between the second capping layer and the plurality of color filter layers,
wherein each of the first color dam and the second color dam is directly disposed on the planarization layer on the second bank.

10. The display device of claim 9, further comprising:
a light blocking member disposed on the planarization layer and overlapping the first bank; and
an overcoat layer disposed on the light blocking member and the plurality of color filter layers.

11. The display device of claim 8, further comprising:
a via layer disposed in the display area and the non-display area on the first substrate;
a third bank disposed on the via layer, spaced apart from the second bank in the non-display area, and surrounding the second bank; and
a first valley part disposed between the first bank and the second bank in the non-display area and penetrating through the via layer.

12. The display device of claim 11, wherein
a plurality of first color dams are disposed on the second bank and the third bank disposed on the first side of the display area, and
a plurality of second color dams are disposed on the second bank and the third bank disposed on the second side of the display area.

13. The display device of claim 11, further comprising a plurality of bank partition walls directly disposed on the via layer between the first bank and the first valley part.

14. The display device of claim 8, wherein
each of the first bank and the second bank includes a base layer and an upper layer disposed on the base layer, and
the upper layer has a greater width than the base layer.

15. The display device of claim 1, wherein
the plurality of sub-pixels include a plurality of electrodes extending in a direction and spaced apart from each other, and
the plurality of light emitting elements are disposed on the plurality of electrodes spaced apart from each other.

16. The display device of claim 1, wherein each of the light emitting elements includes a first electrode disposed on the first substrate, an organic layer disposed on the first electrode, and a second electrode disposed on the organic layer.

17. A display device comprising:
a display area and a non-display area surrounding the display area;
a plurality of sub-pixels disposed in the display area and arranged in a first direction and a second direction intersecting the first direction, each of the plurality of sub-pixels including:
a first electrode;
a second electrode spaced apart from the first electrode; and
a plurality of light emitting elements including first and second ends disposed on the first electrode and the second electrode, respectively;
a first bank extending in the first direction and the second direction in the display area and surrounding the plurality of sub-pixels;
a plurality of color control members disposed in an area surrounded by the first bank;
a plurality of color filter layers disposed on the plurality of color control members;
a first valley part spaced apart from the first bank and surrounding the first bank in the non-display area;
a second bank spaced apart from the first valley part and surrounding the first valley part in the non-display area;
a third bank spaced apart from the second bank and surrounding the second bank in the non-display area;
a plurality of first color dams extending in the first direction in a first dam area of the non-display area adjacent to a first side of the display area in the second direction; and
a plurality of second color dams extending in the first direction in a second dam area of the non-display area adjacent to a second side of the display area in the second direction,
wherein the plurality of first color dams and the plurality of second color dams include different materials.

18. The display device of claim 17, wherein
the plurality of first color dams overlap the second bank and the third bank disposed in the first dam area, and
the plurality of second color dams overlap the second bank and the third bank disposed in the second dam area.

19. The display device of claim 17, wherein
the plurality of color filter layers include:
a plurality of first color filter layers,
a plurality of second color filter layers spaced apart from the plurality of first color filter layers in the second direction, and
a plurality of third color filter layers spaced apart from the plurality of second color filter layers in the second direction,
the first color filter layers, the second color filter layers, and the third color filter layers are adjacent to each other in the second direction,
the plurality of first color dams and the third color filter layer include a same material, and
the plurality of second color dams and the first color filter layer include a same material.

20. The display device of claim 19, further comprising third color dams disposed on the second color dams,
wherein the third color dams and the second color dams include a same material.
